# EUROPEAN PATENT APPLICATION

(11) **EP 1 887 619 A2**
(43) Date of publication of application: **13.02.2008**
(21) Application number: 07113682.4
(22) Date of filing: 02.08.2007
(51) Int. Cl.: H01L 21/336, H01L 21/8234, H01L 21/8238

(54) **MIS transistors with different gate electrodes or gate oxides and method for manufacturing the same**

(30) Priority: 10.08.2006 JP 2006217859
(71) Applicant: MATSUSHITA ELECTRIC INDUSTRIAL CO., LTD., Osaka 571-8501 (JP)
(72) Inventor: Hirase, Junji, Matsushita Electric Industrial Co., Ltd., Osaka, Osaka 540-6207 (JP); Sato, Yoshihiro, Matsushita Electric Industrial Co., Ltd., Osaka, Osaka 540-6207 (JP)
(74) Representative: Grünecker, Kinkeldey, Stockmair & Schwanhäusser Anwaltssozietät

(57) **Abstract**

A semiconductor device includes a first MIS transistor and a second MIS transistor. The first MIS transistor includes: a first gate insulating film (4) formed on a first active region (1a) of a substrate (1); and a first gate electrode (7A) formed on the first gate insulating film (4). The second MIS transistor includes: a second gate insulating film (6) formed on a second active region (1b) of the substrate (1) and having a dielectric constant lower than the first gate insulating film (4); and a second gate electrode (7B) formed on the second gate insulating film (6). Insulating sidewall spacers (8A,8B) having the same structure are formed on respective side faces of the first gate electrode (7A) and the second gate electrode (7B).

## Description

### Background of the Invention

### Field of the Invention

The present invention relates to structures of semiconductor devices and manufacturing methods thereof, and particularly relates to a semiconductor device on which MISFETs (Metal Insulator Semiconductor Field Effect Transistors) including gate insulating films having various thickness are boarded and a manufacturing method thereof.

### Related Art

Recent progress in high integration, enhanced functions, and high-speed operation of semiconductor integrated circuits brings promotion of scaling of gate insulating films of MISFETs (hereinafter referred to it as a MIS transistor). When the gate insulating film is reduced in film thickness to some extent, leak current caused due to direct tunneling increases dramatically, so that power consumption of chips cannot be ignored, which means that an oxide film as a conventional gate insulating film almost reaches the limit in thickness reduction. In view of this, the attention is being focused on gate insulating films formed of high dielectric insulating films having dielectric constants three times or more than the conventional gate oxide film, such as HfO₂, HfSiON, and the like.

Incidentally, in a semiconductor device in which a memory cell, an analog circuit, an I/O circuit, or the like besides a logic circuit are boarded on a single chip, a plurality of power source using elements are built in the single chip. For example, relatively low voltage is used in a region (hereinafter referred to it as a core region) where a logic circuit and the like are arranged while relatively high voltage is used in a region (hereinafter referred to it as an I/O region) where an I/O circuit and the like are arranged.

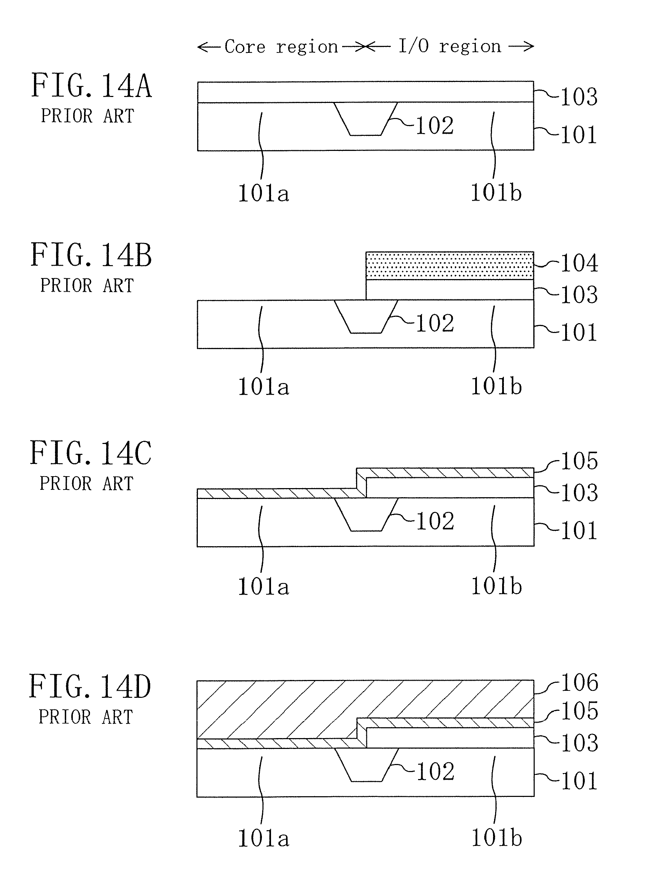

For using a high dielectric gate insulating film in such a consolidated semiconductor device, the process shown in FIG. **14A** to FIG. **14D** has been proposed, for example. Wherein, a MIS transistor formed in the core region has the same conductivity type as a MIS transistor formed in the I/O region.

First, a STI (Shallow Trench Isolation) **102** is formed in a substrate 101 to define an active region **101a** in a core region and an active region **101b** in an I/O region, and a thick gate oxide film **103** is formed on the substrate **101,** as shown in FIG. **14A.**

Next, etching is performed on the thick gate oxide film **103** with the use of a resist pattern **104** covering the I/O region as a mask to remove the thick gate oxide film **103** on the active region **101a** in the core region, as shown in FIG. **14B.**

Subsequently, a high dielectric insulating film **105** is formed on the substrate **101,** namely, on the active region **101a** where the core region is exposed and on the thick gate oxide film **103** covering the active region **101b** in the I/O region, as shown in FIG. **14C,** and then, a gate electrode material film 106 is deposited on the high dielectric insulating film **105,** as shown in FIG. **14D.** Then, though not shown, a gate electrode material film **106** is patterned on the respective active regions **101a, 101b** to form gate electrodes of MIS transistors.

Paten Document 1: Japanese Patent Application Laid Open Publication No. 2004-128316

### Summary of the Invention

In general, it is desirable to use a high dielectric gate insulating film for a low voltage using element in a consolidated semiconductor device. While, such a high dielectric gate insulating film is not necessarily needed for a high voltage using element and is undesirable in some cases because the reliability of the high dielectric gate insulating film is lowered by high voltage application.

In the conventional example shown in FIG. **14A** to FIG. **14D,** however, the high dielectric insulating film 105 is used as both the gate insulating film of the MIS transistor as the low voltage using element formed in the core region and the gate insulating film of the MIS transistor as the high voltage using element formed in the I/O region, and therefore, the semiconductor device cannot cope with such the cases. In other words, the reliability of the gate insulating film of the MIS transistor formed in the I/O region is lowered.

Further, though the above conventional example supposes that the same high dielectric insulating film **105** is used as each gate insulating film of the N-type MIS transistor and the P-type MIS transistor each composing the logic circuit and that the gate insulating films of the N-type MIS transistor and the P-type MIS transistor each composing the I/O circuit have a layered structure in which the same high dielectric insulating film **105** is formed on the gate oxide film **103,** difference in reliability, gate leak characteristics, or the like therebetween makes the degrees of necessity of a high dielectric gate insulating film to be different between the N-type MIS transistor and the P-type MIS transistor in some cases.

For coping with the foregoing, Patent Document 1 provides a technique of separate formation of gate insulating films having different dielectric constants between the MIS transistor of the high voltage using element and the MIS transistor of the low voltage using element. This technique, however, requires separate formation of gate electrodes and of sidewall spacers for the MIS transistors in the respective voltage using elements, thereby complicating the manufacturing method.

In view of the foregoing, the present invention has its object of providing a structure of a semiconductor device in which plural kinds of gate insulating films having different dielectric constants are used separately on a single substrate according to necessity and a simple method for attaining the structure.

To achieve the above object, the inventors figured out that a mask layer is formed on a gate insulating film, which has a relatively high dielectric constant, on one region of a substrate and a gate insulating, which has a relatively low dielectric constant, is selectively formed on another region of the substrate with the use of the mask layer. Wherein, the mask layer may be removed before formation of gate electrodes or may be left as a part of the gate insulating film. According to this invention, a structure of a semiconductor device in which plural kinds of gate insulating films having different dielectric constants are used in a single substrate separately according to necessity can be attained by a simple manufacturing method. Further, according to this invention, the gate electrodes can be formed on the plural kinds of gate insulating films in a single step, and sidewall spacers for covering the side faces of the respective gate electrodes can be formed in a single step, as well.

Specifically, a semiconductor device in accordance with the present invention is a semiconductor device including a first MIS transistor and a second MIS transistor, wherein the first MIS transistor includes: a first gate insulating film formed on a first active region of a substrate; and a first gate electrode formed on the first gate insulating film, the second MIS transistor includes: a second gate insulating film formed on a second active region of the substrate and having a dielectric constant lower than the first gate insulating film; and a second gate electrode formed on the second gate insulating film, and insulting sidewall spacers having the same structure are formed on respective side faces of the first gate electrode and the second gate electrode.

The same structure that the respective insulating sidewall spacers have means that the respective insulating sidewall spacers are formed in the same step with the use of the same insulting film (single layer or multi-layer).

In the semiconductor device in accordance with the present invention, the first gate insulating film may have a film thickness equal to or smaller than the second gate insulating film.

In the semiconductor device in accordance with the present invention, the first MIS transistor and the second MIS transistor may have the same conductivity type, and an operation voltage of the first MIS transistor may be lower than an operation voltage of the second MIS transistor.

In the semiconductor device in accordance with the present invention, the first gate insulating film may have a film thickness larger than the second gate insulating film.

In the semiconductor device in accordance with the present invention, the first MIS transistor may be an N-type MIS transistor while the second MIS transistor may be a P-type MIS transistor.

In the semiconductor device in accordance with the present invention, the first MIS transistor and the second MIS transistor may have the same conductivity type, an operation voltage of the first MIS transistor may be equal to an operation voltage of the second MIS transistor, and a threshold voltage of the first MIS transistor may be higher than a threshold voltage of the second MIS transistor.

In the semiconductor device in accordance with the present invention, the first gate insulating film may include a high dielectric insulating film. In this case, a SiN film may be formed on the high dielectric insulating film, or the high dielectric insulating film may include a nitrided upper part, or a buffer insulating film may be formed below the high dielectric insulating film.

In the semiconductor device in accordance with the present invention, the second gate insulating film may be a SiO₂ film or a SiON film.

In the semiconductor device in accordance with the present invention, the first gate electrode may be a fully silicided electrode while the second gate electrode may be a fully silicided electrode or includes a polysilicon electrode.

In the semiconductor device in accordance with the present invention, the first gate electrode and the second gate electrode may be metal gate electrodes.

In the semiconductor device in accordance with the present invention, the first gate electrode may be a metal gate electrode while the second gate electrode may include a polysilicon electrode in contact with the second gate insulating film.

In the semiconductor device in accordance with the present invention, the first gate electrode may include a metal gate electrode in contact with the first gate insulating film while the second gate electrode may include a polysilicon electrode in contact with the second gate insulating film. In this case, the semiconductor device further may include a third MIS transistor, wherein the third MIS transistor includes: a third gate insulating film formed on a third active region of the substrate and formed of the same insulating film as the first gate insulating film; and a third gate electrode formed on the third gate insulating film, the third gate electrode includes another metal gate electrode in contact with the third gate insulating film, and insulating sidewall spacers having the same structure as the said insulating sidewall spacers are formed on the respective side faces of the third gate electrode.

The semiconductor device in accordance with the present invention may further includes a third MIS transistor, wherein the third MIS transistor includes: a third gate insulating film formed on a third active region of the substrate and having a dielectric constant lower than the first gate insulating film; and a third gate electrode formed on the third gate insulating film, and insulating sidewall spacers having the same structure as the said insulating sidewall spacers are formed on the respective side faces of the third gate electrode.

The semiconductor device manufacturing method in accordance with the present invention is a method for manufacturing a semiconductor device including a first MIS transistor including a first gate insulating film and a first gate electrode and a second MIS transistor including a second gate insulating film and a second gate electrode, the method including the steps of: (a) forming the first gate insulating film on a first active region of a substrate; (b) forming the second gate insulating film, which has a dielectric constant lower than the first gate insulating film, on a second active region of the substrate; (c) forming the first gate electrode on the first gate insulating film; (d) forming the second gate electrode on the second gate insulating film; and (e) forming insulating sidewall spacers having the same structure on respective side faces of the first gate electrode and the second gate electrode.

In the semiconductor device manufacturing method in accordance with the present invention, the first gate insulating film may have a film thickness equal to or smaller than the second gate insulating film.

In the semiconductor device manufacturing method in accordance with the present invention, the first MIS transistor and the second MIS transistor may have the same conductivity type, and an operation voltage of the first MIS transistor may be lower than an operation voltage of the second MIS transistor.

In the semiconductor device manufacturing method in accordance with the present invention, the first gate insulating film may have a film thickness larger than the second gate insulating film.

In the semiconductor device manufacturing method in accordance with the present invention, the first MIS transistor may be an N-type MIS transistor while the second MIS transistor may be a P-type MIS transistor.

In the semiconductor device manufacturing method in accordance with the present invention, the first MIS transistor and the second MIS transistor may have the same conductivity type, an operation voltage of the first MIS transistor may be equal to an operation voltage of the second MIS transistor; and a threshold voltage of the first MIS transistor may be higher than a threshold voltage of the second MIS transistor.

In the semiconductor device manufacturing method in accordance with the present invention, the step (a) may include a step of forming, after forming a high dielectric insulating film on the first active region, an SiN film on the high dielectric insulating film, and the step (b) may include a step of forming the second gate insulating film on the second active region by oxidizing the substrate with the use of the SiN film as a mask after the step (a). In this case, the method may further include the step of: removing the SiN film after the step (b) and before the step (c). Alternatively, the step (a) may include a step of fonning, before forming the high dielectric insulating film, a buffer insulating film on the first active region.

In the semiconductor device manufacturing method in accordance with the present invention, the step (a) may include a step of forming, after forming a high dielectric insulating film on the first active region, a nitride layer by nitriding an upper part of the high dielectric insulating film, and the step (b) may include a step of forming the second gate insulating film on the second active region by oxidizing the substrate with the use of the nitride layer as a mask after the step (a). In this case, the method may further include the step of: removing the nitride layer after the step (b) and before the step (c). Alternatively, the step (a) may include a step of forming, before forming the high dielectric insulating film, a buffer insulating film on the first active region.

In the semiconductor device manufacturing method in accordance with the present invention, the second gate insulating film may be a SiO₂ film or a SiON film.

In the semiconductor device manufacturing method in accordance with the present invention, the first gate electrode and the second gate electrode may be made of polysilicon, and the method may include the step of: fully siliciding at least the first gate electrode after the step (c).

In the semiconductor device manufacturing method in accordance with the present invention, the first gate electrode and the second gate electrode may be metal gate electrodes.

In the semiconductor device manufacturing method in accordance with the present invention, in the step (c), a dummy gate electrode may be formed in place of the first gate electrode, and the method may further include the steps of: (f) removing, after the step (e), the dummy gate electrode and forming a metal gate electrode as the first gate electrode in a recessed portion formed by the removal. In this case, the second gate electrode may be formed of a silicon-containing film, and the method may further include the step of: forming a protection film covering the dummy gate and siliciding a surface portion of the second gate electrode with the use of the protection film as a mask between the step (e) and the step (f), wherein in the step (f), the protection film is removed together with the dummy gate electrode.

In the semiconductor device manufacturing method in accordance with the present invention, in the step (c) and the step (d): a metal film may formed on the first gate insulating film; a polysilicon film may formed on the metal film and the second gate insulating film; and then, patterning may performed on the metal film and the polysilicon film on the first gate insulating film and the polysilicon film on the second gate insulating film to form the first gate electrode and the second gate electrode.

In the semiconductor device manufacturing method in accordance with the present invention, the semiconductor device may further include a third MIS transistor including a third gate insulating film and a third gate electrode, wherein in the step (a), the third gate insulating film, which is made of the same insulating film as the first gate insulating film, is formed on a third active region of the substrate, in the step (c) and the step (d): a first metal film is formed on the first gate insulating film while a second metal film is formed on the third gate insulating film; a polysilicon film is formed on the first metal film, the second metal film, and the second gate insulating film; and then, patterning is performed on the first metal film and the polysilicon film on the first gate insulating film, the polysilicon film on the second gate insulating film, and the second metal film and the polysilicon film on the third gate insulating film to form the first gate electrode, the second gate electrode, and the third gate electrode, respectively, and in the step (e), insulating sidewall spacers having the same structure as the said insulating sidewall spacers are formed on the respective side faces of the third gate electrode.

In the semiconductor device manufacturing method in accordance with the present invention, the semiconductor device may further include a third MIS transistor including a third gate insulating film and a third gate electrode, wherein the method further includes the steps of: (g) forming the third gate insulating film, which has a dielectric constant lower than the first gate insulating film, on a third active region of the substrate before the step (c) and the step (d); and (h) forming the third gate electrode on the third gate insulating film between the step (g) and the step (e), wherein in the step (e), insulating sidewall spacers having the same structure as the said insulating sidewall spacers are formed on the respective side faces of the third gate electrode.

According to the present invention, a structure of a semiconductor device in which plural kinds of gate insulating films having different dielectric constants are used in a single substrate separately according to necessity can be attained by a simple manufacturing method. Hence, high-level enhancement of both the chip performance and the reliability can be achieved.

In sum, the present invention relates to a semiconductor device on which MIS transistors including gate insulating films having various film thicknesses are boarded and manufacturing method thereof, can achieve high-level enhancement of both the chip performance and the reliability when the present invention is applied to various kinds of electronic equipment, and is therefore very useful.

### Brief Description of the Drawings

FIG. **1A** to FIG. **1F** are sectional views showing respective steps of a semiconductor device manufacturing method in accordance with Embodiment 1 of the present invention.
FIG. **2A** to FIG. **2G** are sectional views showing respective steps of a semiconductor device manufacturing method in accordance with a modified example of Embodiment 1 of the present invention.
FIG. **3A** and FIG. **3B** are sectional views showing a semiconductor device in the gate length direction and the gate width direction, respectively, in accordance with Embodiment 2 of the present invention.
FIG. **4** is a sectional view showing a semiconductor device in accordance with Embodiment 3 of the present invention.
FIG. **5A** to FIG. **5F** are sectional views showing respective steps of a semiconductor device manufacturing method in accordance with Embodiment 4 of the present invention.
FIG. **6A** to FIG. **6C** are sectional views showing respective steps of a semiconductor device manufacturing method in accordance with Embodiment 5 of the present invention.
FIG. **7A** to FIG. **7D** are sectional views showing respective steps of a semiconductor device manufacturing method in accordance with a modified example of Embodiment 5 of the present invention.
FIG. **8A** to FIG. **8D** are sectional views showing respective steps of the semiconductor device manufacturing method in accordance with the modified example of Embodiment 5 of the present invention.
FIG. **9A** to FIG. **9D** are sectional views showing respective steps of a semiconductor device manufacturing method in accordance with Embodiment 6 of the present invention.
FIG. **10A** to FIG. **10F** are sectional views showing respective steps of a semiconductor device manufacturing method in accordance with Embodiment 7 of the present invention.
FIG. **11A** to FIG. **11D** are sectional views showing respective steps of the semiconductor device manufacturing method in accordance with Embodiment 7 of the present invention.
FIG. **12A** to FIG. **12E** are sectional views showing respective steps of a semiconductor device manufacturing method in accordance with Embodiment 8 of the present invention.
FIG. **13A** and FIG. **13B** are sectional views showing respective steps of the semiconductor device manufacturing method in accordance with Embodiment 8 of the present invention.
FIG. **14A** to FIG. **14D** are sectional views showing respective steps of a conventional semiconductor device manufacturing method.

### Description of Preferred Embodiments

### (Embodiment 1)

A semiconductor device and a manufacturing method thereof in accordance with Embodiment 1 of the present invention will be described below with reference to the drawings by referring to an example where the structure in the present embodiment is applied to N-type MIS transistors.

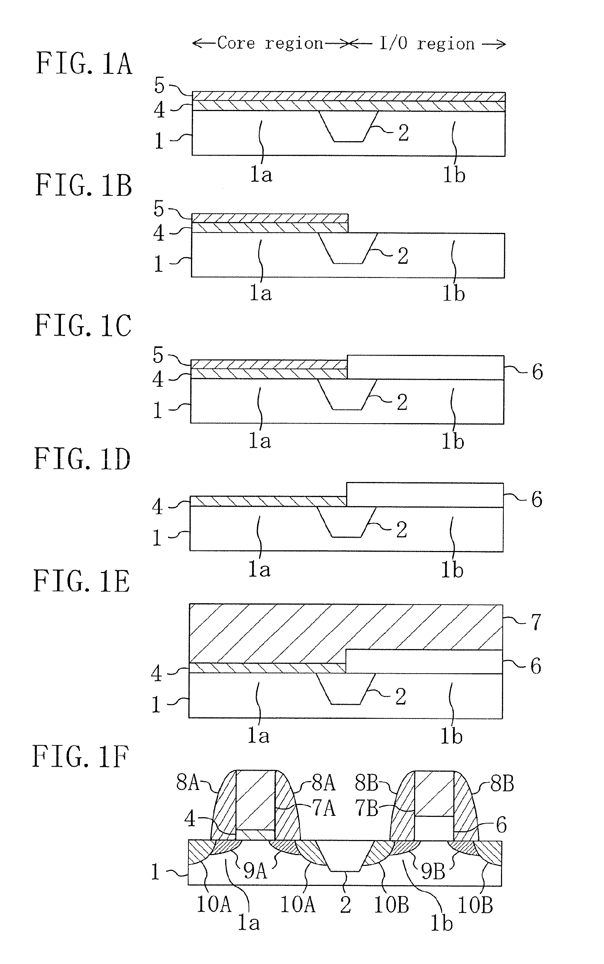

FIG. **1A** to FIG. **1F** are sectional view showing respective steps of the semiconductor device manufacturing method in accordance with the present embodiment. In the present embodiment, a core region means a region where an N-type MIS transistor composing a logic circuit or the like using relatively low voltage is formed, and an I/O region means a region where an N-type MIS transistor composing an I/O circuit or the like using relatively high voltage is formed.

First, as shown in FIG. **1A,** an isolation region **2** of, for example, a STI is formed in a one conductivity type substrate (semiconductor substrate) including a semiconductor region, such as a silicon region or the like to define the core region and the I/O region, and P-type wells, P-type punch through stoppers, and P-type channels are formed, though not shown. Whereby, regions of the substrate **1** which are surrounded by the isolation region **2** serve as an active region **1a** in the core region and an active region **1b** in the I/O region. Referring to implantation conditions, for example: B (boron) ion at a dose of 1x10¹³ cm⁻² is implanted at an implantation energy of 300 keV for forming the P-type wells; B ion at a dose of 1x10¹³ cm⁻² is implanted at an implantation energy of 150 keV for forming the P-type punch through stoppers; and B ion at a dose of 3x10¹² cm⁻² is implanted at an implantation energy of 20 keV for forming the P-type channel regions.

Next, following formation of a resist pattern (not shown) covering the I/O region, B ion at a dose of 5x10¹² cm⁻² is implanted at an implantation energy of 20 keV into only the P-type channel region of the active region **1a** in the core region with the use of the resist pattern as a mask, and then, the resist pattern is removed. This sets the impurity concentration of the P-type channel region of the active region **1a** in the core region to be higher than the impurity concentration of the P-type channel region of the active region **1b** in the I/O region.

Subsequently, a buffer insulating film (not shown) formed of a silicon oxide film having a thickness of, for example, 0.5 nm is formed on the substrate **1,** a gate insulating film (hereinafter referred to as a high dielectric gate insulating film) formed of a HfSiON film having a thickness of, for example, 4 nm (an equivalent oxide thickness of 1 nm) is formed on the buffer insulating film, and then, a nitride film (SiN film) **5** having a thickness of, for example, 2 nm is deposited on the high dielectric gate insulating film 4, as shown in FIG. **1A.** In the following description, the buffer insulating film is included in the high dielectric gate insulating film **4.**

Thereafter, following formation of a resist pattern (not shown) covering the core region, etching is performed sequentially on the nitride film **5** and the high dielectric gate insulating film **4** with the use of the resist pattern to remove the nitride film 5 and the high dielectric gate insulating film **4** on the active region **1b** in the I/O region, and then, the resist pattern is removed, as shown in FIG. **1B.**

Next, as shown in FIG. **1C,** the surface of the active region **1b** in the I/O region is oxidized selectively with the use of the nitride firm **5** formed in the core region as a mask to form a gate oxide film **6** having a thickness of, for example, 8 nm on the active region **1b.** Then, as shown in FIG. **1D,** the nitride film **5** in the core region is removed selectively to expose the high dielectric gate insulating film **4.**

Subsequently, as shown in FIG. **1E,** a gat electrode material film **7** having a thickness of, for example, 100 nm is deposited on the high dielectric gate insulating film **4** and the gate oxide film **6.**

Thereafter, following formation of a resist pattern (not shown) covering a gate electrode formation region on the gate electrode material film **7,** etching is performed sequentially on the gate electrode material film **7,** the high dielectric gate insulating film **4,** and the gate oxide film **6** with the use of the resist pattern as a mask, thereby forming a gate electrode **7A** on the active region **1a** in the core region with the high dielectric gate insulating film **4** interposed while forming a gate electrode **7B** on the active region **1b** in the I/O region with the gate oxide film **6** interposed, as shown in FIG. **1F.** Then, N-type extension regions 9A are formed under the respective sides of the gate electrode 7A in the active region **1a** in the core region, p-type pocket regions (not shown) are formed below the N-type extension regions **9A.** On the other hand, in the active region **1b** in the I/O region, an N-type LLD (lightly dope drain) regions **9B** are formed under the respective sides of the gate electrode **7B.**

Next, after insulating sidewall spacers **8A, 8B** formed of the same insulating film are formed on the respective side faces of the gate electrodes **7A** and **7B,** an N-type impurity ion is implanted into the active region **1a** in the core region and the active region **1b** in the I/O region with the use of the gate electrodes **7A, 7B** and the sidewall spacers **8A, 8B** as a mask. Then, spike RTA (Rapid Thermal Annealing) at a temperature of, for example, 1050 °C is performed to activate the implanted impurity, thereby forming an N-type source/drain regions **10A** under the respective sides of the insulating sidewall spacers **8A** as viewed from the gate electrode **7A** in the active region **1a** in the core region while forming an N-type source/drain regions 10B under the respective sides of the insulating sidewall spacers **8B** as viewed from the gate electrode **7B** in the active region **1b** in the I/O region. Thus, in the present embodiment, both the MIS transistor formed on the active region **1a** in the core region and the MIS transistor formed on the active region **1b** in the I/O region are N-type MIS transistors of the same conductivity type.

In the semiconductor device formed by the above steps in the present embodiment, the high dielectric gate insulating film **4** is used as the gate insulting film of the N-type MIS transistor formed in the core region using relatively low voltage. On the other hand, the gate oxide film 6 is used as the gate insulting film of the N-type MIS transistor formed in the I/O region using relatively high voltage. Accordingly, in the present embodiment, the gate insulating film of the N-type MIS transistor formed in the I/O region using relatively high voltage includes no high dielectric insulating film, so that reliability lowering, which is caused due to application of high voltage to a gate electrode formed on a high dielectric gate insulating film, is obviated in the N-type MIS transistor formed in the I/O region.

Hence, according to Embodiment 1, a structure of a semiconductor device in which plural kinds of gate insulating films having different dielectric constants are used in the single substrate **1** separately according to the film characteristics can be attained by the simple method. This leads to high-level enhancement of both the chip performance and the reliability. Further, the gate electrodes can be formed on the plural kinds of gate insulating films in a single step, and the insulating sidewall spacers **8A, 8B** for respectively covering the side faces of the gate electrodes **7A, 7B** can be formed in a single step, as well. In other words, the insulating sidewall spacers **8A**, **8B** having the same structure are formed on the side faces of the gate electrodes **7A**, **7B**, respectively.

It is noted that though the film thickness of the high dielectric gate insulating film 4 is set smaller than that of the gate oxide film **6** in the present embodiment, the film thickness of the high dielectric gate insulating film **4** may be set equal to that of the gate oxide film **6.**

Further, a HfSiON film is used as the high dielectric gate insulating film **4** in the present embodiment, but the high dielectric gate insulating film 4 may be made of any other suitable material, such as HfO₂, ZrO₂, TiO₂, Ta₂O₅, or the like.

In the present embodiment, the nitride film 5 is formed on the high dielectric gate insulating film **4.** The same effects as in the present embodiment can be achieved even when a nitride layer is formed in the upper part of the high dielectric gate insulating film **4** by nitriding the upper part.

In the present embodiment, a buffer insulating film formed of, for example, a silicon oxide film is preferably inserted between the substrate **1** and the high dielectric gate insulating film **4.** This maintains the interface between the substrate **1** and the high dielectric gate insulating film **4** properly.

The gate oxide film **6** is formed on the active region **1b** in the I/O region in the present embodiment, but a gate insulating film formed of, for example, an SiON film may be formed in place thereof.

The gate electrodes **7A** and **7B** in the present embodiment may be polysilicon electrodes formed of, for example, a polysilicon film having a conductivity type opposite to that of the corresponding wells. In this case, the upper parts of the polysilicon electrodes may be silicided. Alternatively, the gate electrodes **7A** and **7B** may be fully silicided gate electrodes or metal gate electrodes. Or, the gate electrode **7A** may be a fully silicided electrode when the gate electrode **7B** includes a polysilicon electrode. In other words, the gate electrodes **7A** and **7B** may be made of different materials.

Furthermore, in the present embodiment, the upper part of the high dielectric gate insulating film **4** may be nitrided by thermal treatment performed for forming the nitride film **5** or the gate oxide film **6.** Alternatively, nitriding under a nitrogen atmosphere may be performed for further nitriding the upper part of the high dielectric gate insulating film **4** after and/or before the nitride film **5** is removed.

In the present embodiment, the insulating sidewall spacers **8A** and **8B** have a single-layer structure but may have a two- or three-layer structure in combination of an oxide film (a SiO₂ film) and a nitride film, for example.

In addition, the N-type MIS transistors are formed in the core region and the I/O region in the present embodiment, but P-type MIS transistors or CMOS (Complementary Metal-Oxide Semiconductor) transistors may be formed in place thereof.

### (Modified Example of Embodiment 1)

A semiconductor device and a manufacturing method thereof in accordance with a modified example of Embodiment 1 of the present invention will be described with reference to the drawings by refereeing to an example where the structure in the present modified example is applied to N-type MIS transistors.

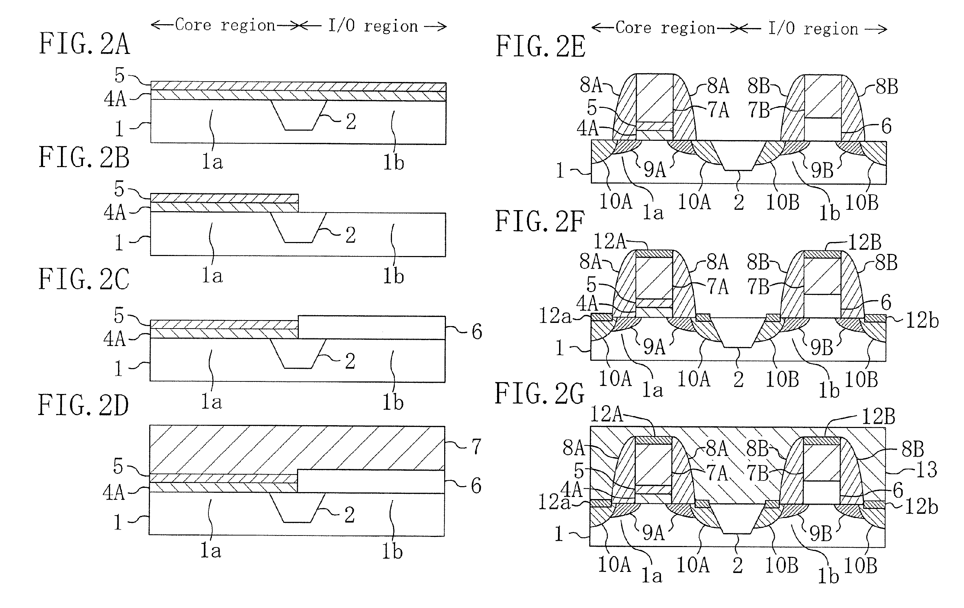

FIG. **2A** to FIG. **2G** are sectional views showing respective steps of the semiconductor device manufacturing method in accordance with the present modified example. In FIG. **2A** to FIG. **2G,** the same reference numerals are assigned to the same elements as those in Embodiment 1 shown in FIG. **1A** to FIG. **1F** for omitting duplicate description. Further, in the present modified example, the core region means a region where an N-type MIS transistor composing a logic circuit or the like using relatively low voltage is formed, and the I/O region means a region where an N-type MIS transistor composing an I/O circuit or the like using relatively high voltage is formed.

Significant difference in the present modified example from Embodiment 1 lies in that the nitride film **5** on a high dielectric insulating film **4A** (corresponding to the high dielectric gate insulating film **4** in Embodiment 1, which is to serve as a gate insulating film in the core region) is left as a part of the gate insulating film, as shown in FIG. **2A** to **FIG. 2G.**

Specifically, first, as shown in FIG. **2A** to FIG. **2C,** a layered structure of the high dielectric insulating film **4A** and the nitride film **5** is formed on the active region **1a** in the core region, and a single-layer structure of the gate oxide film **6** is formed on the active region **1b** in the I/O region, similarly to the steps shown in FIG. **1A** to FIG. **1C** in Embodiment 1.

Next, unlike Embodiment 1, the gate electrode material film **7** formed of a polysilicon film having a thickness of, for example, 100 nm is deposited on the nitride film **5** and the gate oxide film **6** with the nitride film **5** left on the active region **1a** in the core region, as shown in FIG. **2D.**

Subsequently, following formation of a resist pattern (not shown) covering the gate electrode formation region on the gate electrode material film **7,** etching is performed sequentially on the gate electrode material film **7,** the nitride film **5,** the high dielectric insulating film **4A,** and the gate oxide film 6 with the use of the resist pattern as a mask. Thus, the gate electrode **7A** is formed on the active region **1a** in the core region, the gate insulating film having a layered structure of the high dielectric insulating film 4A and the nitride film 5 is interposed therebetween, and the gate electrode 7B is formed on the active region **1b** in the I/O region with the gate oxide film **6** interposed. Then, the N-type extension regions 9A are formed under the respective sides of the gate electrode 7A in the active region **1A** in the core region, and the P-type pocket regions (not shown) are formed below the N-type extension regions **9A.** On the other hand, in the active region **1b** in the I/O region, the N-type LDD regions 9B are formed under the respective sides of the gate electrode 7.

Thereafter, after insulating sidewall spacers **8A, 8B** made of the same insulating film are formed on the side faces of the gate electrodes **7A** and **7B,** respectively, an N-type impurity ion is implanted into the active region **1a** in the core region and the active region **1b** in the I/O region with the use of the gate electrodes **7A, 7B** and the sidewall spacers **8A,** 8B as a mask. Then, spike RTA (Rapid Thermal Annealing) at a temperature of, for example, 1050 °C is performed to activate the implanted impurity. Whereby, the N-type source/drain regions **10A** are formed under the respective sides of the insulating sidewall spacers **8A** as viewed from the gate electrode **7B** in the active region **1a** in the core region while an N-type source/drain regions **10B** are formed under the respective sides of the insulating sidewall spacers **8B** as viewed from the gate electrode **7B** in the active region **1b** in the I/O region.

Next, after a metal film formed of a Ni film having a thickness of, for example, 10 nm is deposited on the substrate **1** including the gate electrodes **7A** and **7B,** RTA is performed, thereby forming an on-gate silicide layers 12A and 12B on the gate electrodes **7A** and **7B,** respectively, while forming on-source/drain silicide layers **12a** and **12b** on the source/drain regions **10A** and **10B,** respectively, as shown in FIG. **2F.** Then, a non-reactive metal film remaining on the substrate 1 is removed.

Subsequently, as shown in FIG. **2G,** an interlayer insulating film **13** having a thickness of, for example, 400 nm is deposited on the entire surface of the substrate **1** including the gate electrodes **7A** and **7B,** and then, the surface of the interlayer insulating film **13** is planarized by CMP (Chemical Mechanical Polishing), for example.

In the semiconductor device formed by the above steps in the present modified example, the layered structure of the high dielectric insulating film **4A** and the nitride film 5 is employed as the gate insulting film of the N-type MIS transistor formed in the core region using relatively low voltage. On the other hand, the gate oxide film 6 is used as the gate insulting film of the N-type MIS transistor formed in the I/O region using relatively high voltage. Accordingly, the gate insulating film of the N-type MIS transistor formed in the I/O region using relatively high voltage includes no high dielectric insulating film, so that reliability lowering, which is caused due to application of high voltage to a gate electrode formed on a high dielectric insulating film, is obviated in the N-type MIS transistor formed in the I/O region.

Accordingly, the present modified example achieves the same effects as those in Embodiment 1. In the N-type MIS transistor formed in the core region, when the layered structure of the high dielectric insulating film **4A** and the nitride film **5** is employed as the gate insulating film, in other words, when the nitride film **5** is inserted between the high dielectric insulating film **4A** and the gate electrode **7A,** degradation of the leak current characteristics and reliability lowering can be prevented with lowering of the dielectric constant suppressed to a minimum.

It is noted that though the total film thickness of the gate insulating film in the layered structure of the high dielectric insulating film **4A** and the nitride film 5 is set smaller than the film thickness of the gate oxide film **6** in the present modified example, the total film thickness of the gate insulating film in the layered structure of the high dielectric insulating film **4A** and the nitride film **5** may be set equal to the film thickness of the gate oxide film **6.**

Further, a HfSiON film is used as the high dielectric insulating film **4A** in the present modified example, but the high dielectric insulating film **4A** may be made of any other suitable material, such as HfO₂, ZrO₂, TiO₂, Ta₂O₅, or the like.

In the present modified example, the nitride film 5 is formed on the high dielectric insulating film **4A.** The same effects as in the present modified example can be achieved even when a nitride layer is formed in the upper part of the high dielectric insulating film **4A** by nitriding the upper part.

In the present modified example, a buffer insulating film formed of, for example, a silicon oxide film is preferably inserted between the substrate **1** and the high dielectric insulating film **4A.** This maintains the interface between the substrate **1** and the high dielectric insulating film 4A properly.

The gate oxide film **6** is formed on the active region **1b** in the I/O region in the present modified example, but a gate insulating film formed of, for example, an SiON film may be formed in place thereof.

The gate electrodes **7A** and **7B** in the present modified example may be polysilicon electrodes formed of, for example, a polysilicon film having a conductivity type opposite to that of the corresponding wells. In this case, the upper parts of the polysilicon electrodes may not be silicided. Alternatively, the gate electrodes **7A** and **7B** may be fully silicided gate electrodes or metal gate electrodes. Or, the gate electrode **7A** may be a fully silicided electrode when the gate electrode **7B** includes a polysilicon electrode. In other words, the gate electrodes **7A** and **7B** may be made of different materials.

Furthermore, in the present modified example, the upper part of the high dielectric insulating film **4A** may be nitrided by thermal treatment performed for forming the nitride film **5** or the gate oxide film **6.**

In the present modified example, the insulating sidewall spacers **8A** and **8B** have a single-layer structure but may have a two- or three-layer structure in combination of an oxide film and a nitride film, for example.

In addition, the N-type MIS transistors are formed in the core region and the I/O region in the present modified example, but P-type MIS transistors or CMOS transistors may be formed in place thereof.

### (Embodiment 2)

A semiconductor device and a manufacturing method thereof in accordance with Embodiment 2 of the present invention will be described below with reference to the drawings.

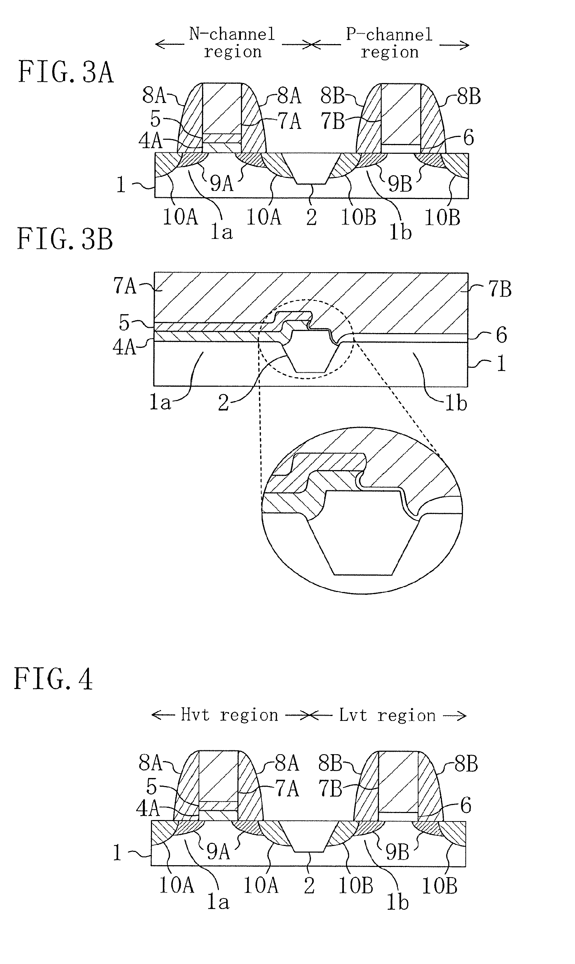

FIG. **3A** is a sectional view of the semiconductor device in the gate length direction in accordance with the present embodiment, and FIG. **3B** is a sectional view with a partially enlarged view of the semiconductor device in the gate width direction in accordance with the present embodiment. In FIG. **3A** and FIG. **3B,** the same reference numerals are assigned to the same elements as those in Embodiment 1 shown in FIG. **1A** to FIG. **1F** or in the modified example thereof shown in FIG. **2A** to FIG. **2G** for omitting duplicate description. In the present embodiment, an N-channel region means a region where an N-type MIS transistor is formed, and a P-channel region means a region where a P-type MIS transistor is formed.

Referring to the modified example of Embodiment 1 shown in **FIG.2A** to FIG. **2G,** the layered structure of the high dielectric insulating film **4A** and the nitride film **5** is employed as the gate insulating film of the N-type MIS transistor formed in the core region using relatively low voltage while the gate oxide film **6** in the single-layer structure is used as the gate insulating film of the N-type MIS transistor formed in the I/O region using relatively high voltage.

In contrast, in the present embodiment, the layered structure of the high dielectric insulating film **4A** and the nitride film **5** is employed as the gate insulating film of an N-type MIS transistor formed in the N-channel region while the gate oxide film 6 in the single-layer structure is used as the gate insulating film of a P-type MIS transistor formed in a P-channel region, as shown in FIG. **3A** and FIG. **3B**.

In the present embodiment, the film thickness of the gate insulating film of the N-type MIS transistor is larger than that of the gate insulating film of the P-type MIS transistor. Specifically, the high dielectric insulating film **4A** is a HfSiON film having a thickness of, for example, 4 nm (an equivalent oxide thickness of 1 nm), and the nitride film 5 has a thickness of, for example, 2 nm. On the other hand, the gate oxide film **5** has a thickens of, for example, 1.5 nm.

In the present embodiment, as shown in FIG. **3B,** the gate electrode **7A** of the N-type MIS transistor and the gate electrode **7B** of the P-type MIS transistor are connected to each other at the boundary on the isolation region **2** between the N-channel region and the P-channel region in the gate width direction. The gate insulating film of the N-type MIS transistor in the layered structure of the high dielectric insulating film **4A** and the nitride film **5** is in contact with the gate insulating film of the P-type MIS transistor formed of the gate oxide film **6** in the single-layer structure, which invites change in shape at the side face of the gate insulating film formed of the high dielectric insulating film **4A** and the nitride film **5.** Specifically, gate oxidation at a high temperature exceeding, for example, 1000 °C for forming the gate oxide film **6** also oxidizes the side faces of the high dielectric insulating film **4A,** as shown in FIG. **3B** (especially, in the enlarged view of the boundary portion between the N-channel region and the P-channel region), thereby inviting local formation of the gate oxide film 6 in the N-channel region.

Except the aforementioned difference, the semiconductor device manufacturing method in the present embodiment is basically the same as that in the modified example of Embodiment 1, as shown in FIG. **2A** to FIG. **G.**

In the semiconductor device of the present embodiment, the high dielectric insulating film **4A** is used as the gate insulating film of the N-type MIS transistor in which the gate leak current is liable to flow due to the presence of electrons as carrier, and accordingly, the gate leak current can be suppressed. On the other hand, in the P-type MIS transistor in which the gate leak current less flows due to the presence of holes as carriers, the gate oxide film **6** is used as the gate insulting film for contributing to reduction in film thickness thereof. Thus, degradation of the gate insulating film (NBTI: Negative Bias Temperature Instability), which is caused due to the use of a high dielectric insulating film as the gate insulating film of a P-type MIS transistors can be prevented.

Hence, in Embodiment 2, a structure of a semiconductor device in which plural kinds of gate insulating films having different dielectric constants are used in the single substrate **1** separately according to the film characteristic can be attained by the simple manufacturing method. This leads to high-level enhancement of both the chip performance and the reliability. Further, the gate electrodes can be formed on the plural kinds of gate insulating films in a single step, and the insulating sidewall spacers **8A** and **8B** for respectively covering the side faces of the gate electrodes **7A** and **7B** can be formed in a single step, as well. The insulating sidewall spacers **8A** and **8B** respectively formed on the side faces of the gate electrode **7A** and **7B** have the same structure.

In Embodiment 2, insertion of the nitride film 5 between the high dielectric insulating film **4A** and the gate electrode **7A** in the N-type MIS transistor suppresses lowering of the dielectric constant while preventing the leak current characteristics and the reliability from lowering.

In the present embodiment, the nitride film **5** is formed on the high dielectric insulating film **4A,** but the same effects as in the present embodiment can be achieved when a nitride layer is formed in the upper part of the high dielectric insulating film **4A** by nitriding the upper part.

Though the nitride film **5** is left on the high dielectric insulating film **4A** as a part of the gate insulating film of the N-type MIS transistor in the present embodiment, the nitride film **5** may be removed after the gate oxide film **6** is formed and before the gate electrode **7A** is formed.

In the present embodiment, a HfSiON film is used as the high dielectric insulating film 4A, but any other suitable high dielectric insulating film made of HfO₂, ZrO₂, TiO₂, Ta₂O₅, or the like may be used.

It is preferable in the present embodiment to insert a buffer insulating film formed of, for example, a silicon oxide film between the substrate **1** and the high dielectric insulating film **4A.** This maintains the interface between the substrate **1** and the high dielectric insulating film **4A** properly.

Though the gate oxide film **6** is formed as the gate insulating film of the P-type MIS transistor in the present embodiment, a gate insulating film formed of, for example, SiON film may be formed in place thereof.

The gate electrodes **7A** and **7B** in the present embodiment may be polysilicon electrodes formed of, for example, a polysilicon film having a conductivity type opposite to that of the corresponding wells. In this case, the upper parts of the polysilicon electrodes may be silicided. Alternatively, the electrodes **7A** and **7B** may fully silicided gate electrodes or metal gate electrodes. Or, the gate electrode **7A** may be a fully silicided electrode when the gate electrode **7B** includes a polysilicon electrode. In other words, the gate electrodes **7A** and **7B** may be made of different materials.

Furthermore, in the present embodiment, the upper part of the high dielectric insulating film **4A** may be nitrided by thermal treatment performed for forming the nitride film 5 or the gate oxide film **6.**

In the present embodiment, the insulating sidewall spacers **8A** and **8B** have a single-layer structure but may have a two- or three-layer structure in combination of an oxide film and a nitride film, for example.

Further, in the present embodiment, the layered structure of the high dielectric insulating film **4A** and the nitride film **5** is employed as the gate insulating film of the N-type MIS transistor formed in the N-channel region while the gate oxide film 6 is used as the gate insulating film of the P-type MIS transistor formed in the P-channel region. Instead, the layered structure of the high dielectric insulating film **4A** and the nitride film **5** may be employed as the gate insulating film of the P-type MIS transistor with the gate oxide film **6** used as the gate insulating film of the N-type MIS transistor.

### (Embodiment 3)

A semiconductor device and a manufacturing method thereof in accordance with Embodiment 3 of the present invention will be described below with reference to the drawings by referring to an example where the structure in the present embodiment is applied to N-type MIS transistors.

FIG. **4A** is a sectional view of the semiconductor device in accordance with the present embodiment. In FIG. **4,** the same reference numerals are assigned to the same elements as those in Embodiment 1 shown in FIG. **1A** to FIG. **1F** or in the modified example thereof shown in FIG. **2A** to FIG. **2G** for omitting duplicate description. In the present embodiment, a Hvt region means a region where an N-type MIS transistor having relatively high threshold voltage is formed, and a Lvt region means a region where an N-type MIS transistor having relatively low threshold voltage is formed.

Referring to the modified example of Embodiment 1 shown in FIG.**2A** to FIG. **2G,** the layered structure of the high dielectric insulating film **4A** and the nitride film **5** is employed as the gate insulating film of the N-type MIS transistor formed in the core region using relatively low voltage while the gate oxide film **6** in the single-layer structure is used as the gate insulating film of the N-type MIS transistor formed in the I/O region using relatively high voltage.

In contrast, in the present embodiment, the layered structure of the high dielectric insulating film **4A** and the nitride film 5 is employed as the gate insulating film of an N-type MIS transistor formed in the Hvt region while the gate oxide film **6** in the single-layer structure is used as the gate insulating film of an N-type MIS transistor formed in the Lvt region, as shown in FIG. **4.**

The operation voltage of the N-type MIS transistor formed in the Hvt region is equal to the operation voltage of the N-type MIS transistor formed in the Lvt region, and the threshold voltage of the N-type MIS transistor formed in the Hvt region is higher than the threshold voltage of the N-type MIS transistor formed in the Lvt region.

Further, in the present embodiment, the film thickness of the gate insulating film of the N-type MIS transistor formed in the Hvt region is larger than the film thickness of the N-type MIS transistor formed in the Lvt region. Specifically, the high dielectric insulating film **4A** is formed of an HfSiON film having a film thickness of, for example, 4 nm (an equivalent oxide thickness of 1 nm), and the nitride film **5** has a film thickness of, for example, 2 nm. On the other hand, the gate oxide film **6** has a film thickness of, for example, 1.5 nm.

Except the aforementioned difference, the semiconductor device manufacturing method in the present embodiment is basically the same as that in the modified example of Embodiment 1 shown in FIG. **2A** to FIG. **2G.**

In general, the use of a high dielectric insulating film as a gate insulating film may cause Fermi level pinning (fixation of the work function of a gate electrode around the midgap level) to set the threshold voltage Vt high. In view of this, in the present embodiment, a region where Fermi level pinning would be caused in the presence of the high dielectric insulating film is set as the Hvt region while the gate oxide film, which causes no Fermi level pinning, is used in the Lvt region of which threshold voltage Vt should be low.

Hence, in Embodiment 3, a structure of a semiconductor device in which plural kinds of gate insulating films having different dielectric constants are used in the single substrate 1 separately according to the film characteristics can be attained by the simple manufacturing method. This leads to high-level enhancement of both the chip performance and the reliability. Further, the gate electrodes can be formed on the plural kinds of gate insulating films in a single step, and the insulating sidewall spacers **8A** and **8B** for respectively covering the side faces of the gate electrodes **7A** and **7B** can be formed in a single step, as well. The insulating sidewall spacers **8A** and **8B** respectively formed on the side faces of the gate electrode **7A** and **7B** have the same structure.

In Embodiment 3, insertion of the nitride film **5** between the high dielectric insulating film **4A** and the gate electrode **7A** in the N-type MIS transistor formed in the Hvt region suppresses lowering of the dielectric constant while preventing the leak current characteristics and the reliability from lowering.

In the present embodiment, the nitride film **5** is formed on the high dielectric insulating film **4A,** but the same effects as in the present embodiment can be achieved when a nitride layer is formed in the upper part of the high dielectric insulating film **4A** by nitriding the upper part.

Though the nitride film **5** is left on the high dielectric insulating film **4A** as a part of the gate insulating film of the N-type MIS transistor formed in the Hvt region in the present embodiment, the nitride film **5** may be removed after the gate oxide film **6** is formed and before the gate electrode **7A** is formed.

In the present embodiment, a HfSiON film is used as the high dielectric insulating film **4A,** but any other suitable high dielectric insulating film made of HfO₂, ZrO₂, TiO₂, Ta₂O₅, or the like may be used.

It is preferable in the present embodiment to insert a buffer insulating film formed of, for example, a silicon oxide film between the substrate **1** and the high dielectric insulating film **4A.** This maintains the interface between the substrate **1** and the high dielectric insulating film **4A** properly.

Though the gate oxide film 6 is formed as the gate insulating film of the N-type MIS transistor formed in the Lvt region in the present embodiment, a gate insulating film formed of, for example, a SiON film may be formed in place thereof.

The gate electrodes **7A** and **7B** in the present embodiment may be polysilicon electrodes formed of, for example, a polysilicon film having a conductivity type opposite to that of the corresponding wells. In this case, the upper parts of the polysilicon electrodes may be silicided. Alternatively, the electrodes **7A** and **7B** may be fully silicided gate electrodes or metal gate electrodes. Or, the gate electrode **7A** may be a fully silicided electrode when the gate electrode **7B** includes a polysilicon electrode. In other words, the gate electrodes **7A** and **7B** may be made of different materials.

Furthermore, in the present embodiment, the upper part of the high dielectric insulating film **4A** may be nitrided by thermal treatment performed for forming the nitride film **5** or the gate oxide film **6.**

In the present embodiment, the insulating sidewall spacers **8A** and **8B** have a single-layer structure but may have a two- or three-layer structure in combination of an oxide film and a nitride film, for example.

In addition, in the present embodiment, the N-type MIS transistors are formed in the Hvt region and the Lvt region, but P-type transistors or CMOS transistors may be formed in place thereof.

### (Embodiment 4)

A semiconductor device and a manufacturing method thereof in accordance with Embodiment 4 of the present invention will be described below with reference to the drawings by referring an example where the structure in the present embodiment is applied to N-type MIS transistors.

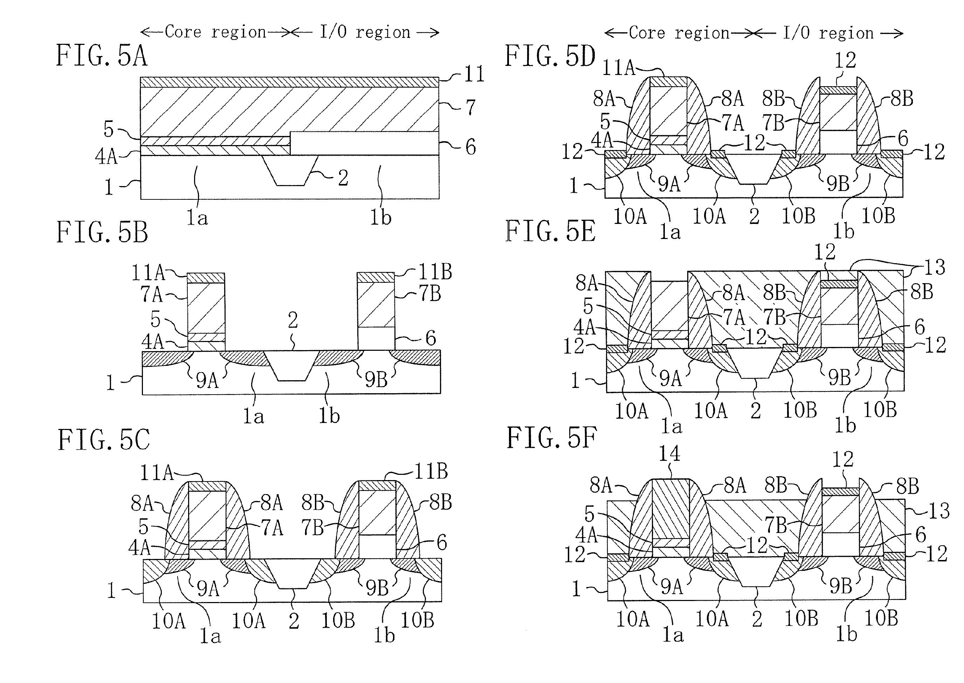

FIG. **5A** to FIG. **5F** are sectional views showing respective steps of the semiconductor device manufacturing method in accordance with the present embodiment. In FIG. **5A** to FIG. **5F**, the same reference numerals are assigned to the same elements as those in Embodiment 1 shown in FIG. **1A** to FIG. **1F** for omitting duplicate description. Further, in the present embodiment, the core region means a region where an N-type MIS transistor composing a logic circuit or the like using relatively low voltage is formed, and the I/O region means a region where an N-type MIS transistor composing an I/O circuit or the like using relatively high voltage is formed.

First, similarly to the steps shown in FIG. **2A** to FIG. **2C** in the modified example of Embodiment 1, the gate insulating film in the layered structure of the high dielectric insulating film **4A** and the nitride film **5** is formed on the active region **1a** in the core region, and the gate insulating film in a single-layer structure of the gate oxide film 6 is formed on the active region **1b** in the I/O region, as shown in FIG. **5A.** Then, the gate electrode material film 7 having a thickness of, for example, 100 nm is deposited on the nitride film 5 and the gate oxide film **6** with the nitride film 5 left in the core region. A protection film **11** formed of a silicon oxide film having a thickness of, for example, 10 nm is formed on the gate electrode material film **7.**

Next, following formation of a resist pattern (not shown) covering the gate electrode formation region on the protection film **11,** etching is performed sequentially on the protection film **11,** the gate electrode material film **7,** the nitride film **5,** the high dielectric insulating film **4A,** and the gate oxide film **6** with the use of the resist pattern as a mask. Thus, the gate electrode **7A** and a protection film **11A** are formed on the active region **1a** in the core region, the gate insulating film in the layered structure of the high dielectric insulating film **4A** the nitride film **5** is interposed therebetween, and the gate electrode **7B** and a protection film **11B** are formed on the active region **1b** in the I/O region with the gate oxide film **6** interposed, as shown in FIG. **5B.** Then, P (phosphorous) ion at a dose of 1x10¹³ cm⁻¹² is implanted into the active region **1b** in the I/O region at an implantation energy of 30 keV with the use of a resist pattern (not shown) covering the core region as a mask to form the N-type LDD regions 9B under the respective sides of the gate electrode **7B** in the active region **1b** in the I/O region. Then, ion implantation of As (arsenic) ion at a dose of 1x10¹⁵ cm⁻² at an implantation energy of 2 keV and ion implantation of B ion at a dose of 3x10¹³ cm⁻² at an implantation energy of 10 keV are sequentially performed on the active region **1a** in the core region with the use of a resist pattern (not shown) covering the active region **1a** in the I/O region to form the N-type extension regions **9A** and the P-type pocket regions (not shown) under the respective sides of the gate electrode **7A** in the active region **1a** in the core region.

Subsequently, an insulating film formed of a SiN film having a thickness of, for example, 50 nm is deposited on the substrate **1** including the gate electrodes **7A** and **7B** and is etched back to form the insulating sidewall spacers **8A** and **8B** on the side faces of the gate electrodes **7A** and **7B,** respectively, as shown in FIG. **5C.** Then, As ion at a dose of 3x10¹⁵ cm⁻² is implanted into the active region **1a** in the core region and the active region **1b** in the I/O region at an implantation energy of 10 keV with the use of the gate electrodes **7A, 7B** and the sidewall spacers **8A, 8B** as a mask, and spike RTA is performed at a temperature of, for example, approximately 1050 °C, thereby forming the N-type source/drain regions 10A under the respective sides of the insulating sidewall spacers 8A as viewed from the gate electrode **7A** in the active region **1a** in the core region while forming the N-type source/drain regions **10B** under the respective sides of the insulating sidewall spacers **8B** as viewed from the gate electrode **7B** in the active region **1b** in the I/O region.

Thereafter, after the protection film **11B** on the gate electrode **7B** in the I/O region is removed and a metal film formed of a Ni film having a thickness of, for example, 10 nm is deposited on the substrate **1** including the gate electrode **7A** and **7B,** RTA is performed to form a silicide layer **12** on the source/drain regions **10A** and **10B** and on the gate electrode **7B** in the I/O region, as shown in FIG. **5D.** In RTA, the gate electrode **7A** in the core region is covered with the protection film **11A,** so that no silicide layer is formed on the gate electrode **7A.** Then, a non-reactive metal film remaining on the substrate **1** is removed.

In the present embodiment, each thickness of the protection film **11** and the silicide layer **12** is set so that the upper face of the silicide layer **12** formed on the gate electrode **7B** is lower in level than the upper end of the insulating sidewall spacers **8B.** Whereby, a recessed portion surrounded by the insulating sidewall spacers **8B** remains on the gate electrode **7B** even after the silicide layer **12** is formed on the gate electrode **7B.**

Next, the interlayer insulating film **13** having a thickness of, for example, 400 nm is deposited on the substrate **1** including the gate electrodes **7A** and **7B** and is shaved by, for example, CMP to expose the protection film **11A** on the gate electrode **7A** in the core region, and then, the protection film **11A** on the gate electrode **7A** is removed selectively, as shown in FIG. **5E.** After etching, a part of the interlayer insulating film **13** is left within the recessed portion surrounded by the insulating sidewall spacers 8B on the gate electrode **7B** in the I/O region.

Subsequently, a metal film formed of a Ni film having a thickness of, for example, 100 nm is deposited on the substrate **1** including the gate electrodes **7A** and **7B,** and then, RTA is performed, thereby siliciding fully the polysilicon film composing the gate electrode **7A** in the core region to thus form a FUSI gate electrode **14,** as shown in FIG. **5F**. In RTA, the polysilicon film composing the gate electrode **7B,** of which upper part is covered with the interlayer insulating film **13,** is not silicided, so that the gate electrode **7B** made of polysilicon remains. Then, the interlayer insulating film **13** formed on the silicide layer **12** is removed to expose the silicide layer **12** on the gate electrode **7B.**

In the semiconductor device formed by the above steps in the present embodiment, the layered structure of the high dielectric insulating film **4A** and the nitride film **5** is employed as the gate insulting film of the N-type MIS transistor formed in the core region using relatively low voltage. On the other hand, the gate oxide film **6** in the single-layer structure is used as the gate insulting film of the N-type MIS transistor formed in the I/O region using relatively high voltage. Accordingly, reliability lowering, which is caused due to application of high voltage to a gate electrode formed on a high dielectric gate insulating film, is obviated.

Accordingly, the present embodiment achieves the same effects as in Embodiment 1. In the N-type MIS transistor formed in the core region, insertion of the nitride film **5** between the high dielectric insulating film **4A** and the FUSI gate electrode **14** suppresses lowering of the dielectric constant and prevents the leak current characteristics and the reliability from lowering. Further, the present embodiment attains a structure using the FUSI gate electrode **14** as a gate electrode in the core region by the above comparatively simple manufacturing method.

It is noted that though the total film thickness of the gate insulating film in the layered structure of the high dielectric insulating film **4A** and the nitride film **5** is set smaller than the film thickness of the gate oxide film **6** in the present embodiment, the total film thickness of the gate insulating film in the layered structure of the high dielectric insulating film **4A** and the nitride film **5** may be set equal to the film thickness of the gate oxide film **6.**

In the present embodiment, the nitride film **5** is formed on the high dielectric insulating film **4A.** The same effects as in the present embodiment can be achieved even when a nitride layer is formed in the upper part of the high dielectric insulating film **4A** by nitriding the upper part.

Though the nitride film **5** is left on the high dielectric insulating film **4A** as a part of the gate insulating film of the N-type MIS transistor formed in the core region in the present embodiment, the nitride film **5** may be removed after the gate oxide film **6** is formed and before the gate electrode **7A** is formed.

Further, a HfSiON film is used as the high dielectric insulating film **4A** in the present embodiment, but the high dielectric insulating film **4A** may be made of any other suitable material, such as HfO₂, ZrO₂, TiO₂, Ta₂O₅, or the like.

In the present embodiment, a buffer insulating film formed of, for example, a silicon oxide film is preferably inserted between the substrate 1 and the high dielectric insulating film **4A.** This maintains the interface between the substrate **1** and the high dielectric insulating film **4A** properly.

The gate oxide film **6** is formed on the active region **1b** in the I/O region in the present embodiment, but a gate insulating film formed of, for example, an SiON film may be formed in place thereof.

In the present embodiment, though only the gate electrode **7A** in the core region is fully silicided, the gate electrode **7B** in the I/O region may be silicided fully as well.

The upper part of the gate electrode **7B** in the I/O region is silicided in the present embodiment, but may not be silicided.

Further, in the present embodiment, the upper part of the high dielectric insulating film **4A** may be nitrided by thermal treatment performed for forming the nitride film 5 or the gate oxide film 6.

In the present embodiment, the insulating sidewall spacers **8A** and **8B** have a single-layer structure but may have a two- or three-layer structure in combination of an oxide film and a nitride film, for example.

Moreover, the N-type MIS transistors are formed in the core region and the I/O region in the present embodiment, but P-type MIS transistors or CMOS transistors may be formed in place thereof.

In addition, in the present embodiment, the FUSI gate electrode is provided on the high dielectric insulating film **4A** in the semiconductor device or the manufacturing method thereof in Embodiment 1 (strictly, the modified example thereof), but may be provided thereon in the semiconductor device and the manufacturing method thereof in Embodiment 2 or 3.

### (Embodiment 5)

A semiconductor device and a manufacturing method thereof in accordance with Embodiment 5 of the present invention will be described below with reference to the drawings by referring an example where the structure in the present embodiment is applied to N-type MIS transistors.

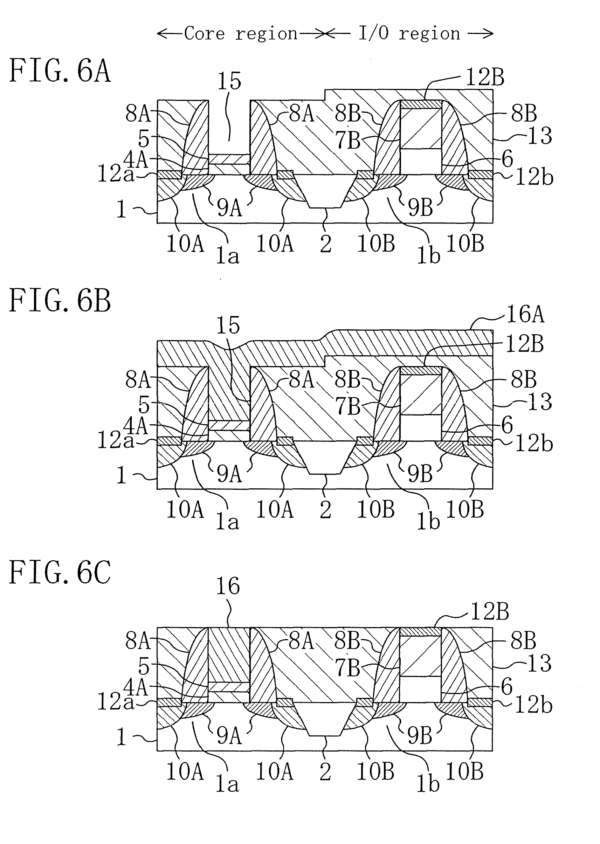

FIG. **6A** to FIG. **6C** are sectional views showing respective steps of the semiconductor device manufacturing method in accordance with the present embodiment. In FIG. **6A** to FIG. **6C,** the same reference numerals are assigned to the same elements as those in Embodiment 1 shown in FIG. **1A** to FIG. **1F** or in the modified example thereof shown in FIG. **2A** to FIG. **2G** for omitting duplicate description. In the present embodiment, the core region means a region where an N-type MIS transistor composing a logic circuit or the like using relatively low voltage is formed, and the I/O region means a region where an N-type MIS transistor composing an I/O circuit or the like using relatively high voltage is formed.

In the present embodiment, the steps shown in FIG. **2A** to FIG. **2G** in the modified example of Embodiment 1 are performed first. Then, a resist pattern (not shown) opening to the core region and covering the I/O region is formed on the interlayer insulating film **13,** and the interlayer insulating film **13** is removed by etching using the resist pattern as an etching mask to expose the on-gate silicide layer **12A** in the core region. The on-gate silicide layer **12A** exposed in the core region and the gate electrode **7A** are removed by etching sequentially to form a gate electrode formation trench **15,** as shown in FIG. **6A.** This exposes the nitride film **5** within the gate electrode formation trench **15.**

Next, as shown in FIG. **6B,** a metal film (preferably a film made of metal having a work function a little larger than 4 eV, such as TaN or the like) **16A** having a thickness of, for example, 150 nm is formed on the entire surface of the substrate **1** including the gate electrode formation trench **15.** Then, the metal film **16** outside the gate electrode formation trench **15** is polished and removed by CMP to form a metal gate electrode **16** made of the metal film **16A** filled in the gate electrode formation trench **15,** as shown in FIG. **6C.** Wherein, the interlayer insulating film **13** and the metal film **16A** on the on-gate silicide layer **12B** are polished and removed by CMP so as to expose the upper face of the on-gate silicide layer **12B** in the I/O region.

By the above steps of the comparatively simple semiconductor device manufacturing method, a semiconductor device exhibiting the same effects as in Embodiment 1 or the modified example thereof can be attained even in the case where the present invention is applied to a damascene gate (replacement gate) process.

It is noted that though the total film thickness of the gate insulating film in the layered structure of the high dielectric insulating film **4A** and the nitride film **5** is set smaller than the film thickness of the gate oxide film **6** in the present embodiment as in the modified example of Embodiment 1, the total film thickness of the gate insulating film in the layered structure of the high dielectric insulating film **4A** and the nitride film 5 may be set equal to the film thickness of the gate oxide film **6.**

Further, a HfSiON film is used as the high dielectric insulating film **4A** in the present embodiment as in the modified example of Embodiment 1, but the high dielectric insulating film **4A** may be made of any other suitable material, such as HfO₂, ZrO₂, TiO₂, Ta₂O₅, or the like.

In the present embodiment, as in the modified example of Embodiment 1, the nitride film 5 is formed on the high dielectric insulating film **4A.** The same effects as in the present embodiment can be achieved even when a nitride layer is formed in the upper part of the high dielectric insulating film **4A** by nitriding the upper part.

Though the nitride film **5** is left on the high dielectric insulating film **4A** as a part of the gate insulating film of the N-type MIS transistor formed in the core region in the present embodiment, the nitride film **5** may be removed after the gate oxide film **6** is formed and before the gate electrode **7A** is formed.

In the present embodiment, a buffer insulating film formed of, for example, a silicon oxide film is preferably inserted between the substrate **1** and the high dielectric insulating film **4A.** This maintains the interface between the substrate **1** and the high dielectric insulating film **4A** properly.

The gate oxide film **6** is formed on the active region **1b** in the I/O region in the present embodiment as in the modified example of Embodiment 1, but a gate insulating film formed of, for example, an SiON film may be formed in place thereof.

Furthermore, in the present embodiment, the upper part of the high dielectric insulating film **4A** may be nitrided by thermal treatment performed for forming the nitride film 5 or the gate oxide film **6.**

In the present embodiment, as in the modified example of Embodiment 1, the insulating sidewall spacers **8A** and **8B** have a single-layer structure, but may have a two- or three-layer structure in combination of an oxide film and a nitride film, for example.

The present embodiment refers to the case where the N-type MIS transistors are formed in the core region and the I/O region, but P-type MIS transistors or CMOS transistors may be formed in place thereof. In the case where the P-type MIS transistors are formed, a material having a work function around 5 eV, such as TaAlN or the like is preferable as the material of the metal gate electrode **16.**

In addition, the present embodiment is directed to a semiconductor device including the core region and the I/O region, but may be directed to a semiconductor device including an N-channel region and a P-channel region or a semiconductor device including a Hvt region and a Lvt region with plural kinds of gate insulating films having different dielectric constants used on a single substrate.

### (Modified Example of Embodiment 5)

A semiconductor device and a manufacturing method thereof in accordance with a modified example of Embodiment 5 of the present invention will be described with reference to the drawings by referring to an example where the structure in the present modified example is applied to N-type MIS transistors.

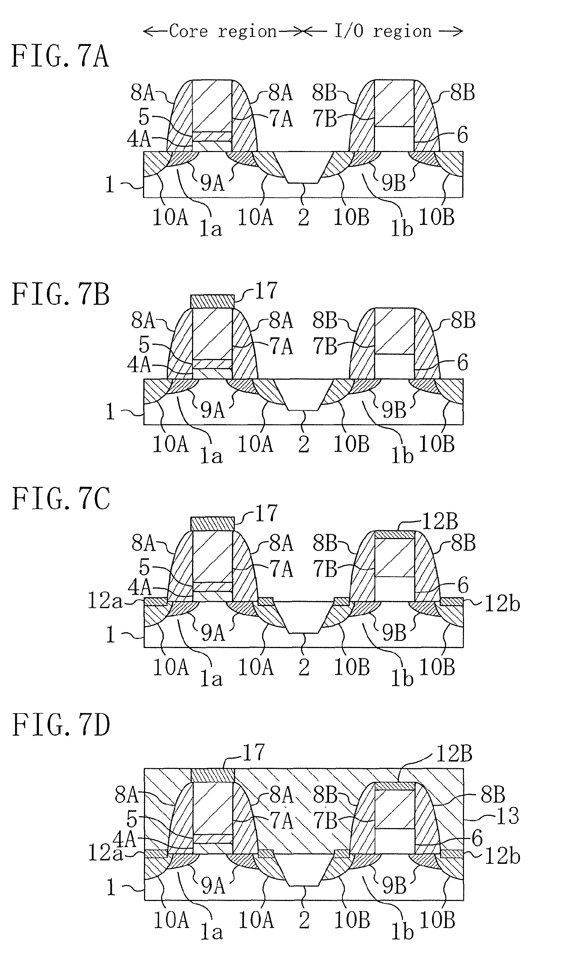

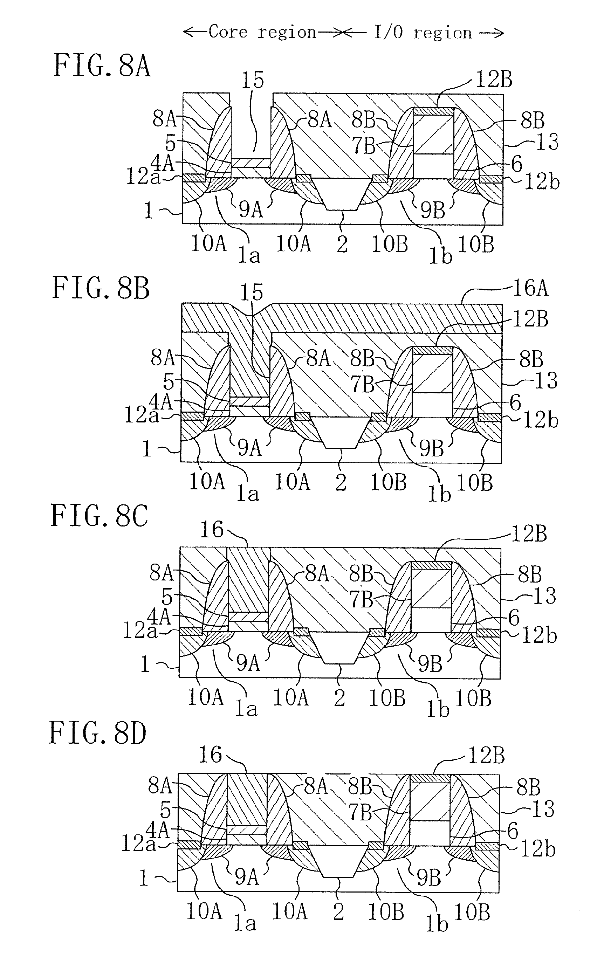

FIG. **7A** to FIG. **7D** and FIG. **8A** to FIG. **8D** are sectional views showing respective steps of the semiconductor device manufacturing method in accordance with the present modified example. In FIG. **7A** to FIG. **7D** and FIG. **8A** to FIG. **8D,** the same reference numerals are assigned to the same elements as those in Embodiment 1 shown in FIG. **1A** to FIG. **1F,** in the modified example of Embodiment 1 shown in FIG. **2A** to FIG. **2G,** or in Embodiment 5 shown in FIG. **6A** to FIG. **6C** for omitting duplicate description. Further, in the present modified example, the core region means a region where an N-type MIS transistor composing a logic circuit or the like using relatively low voltage is formed, and the I/O region is a region where an N-type MIS transistor composing an I/O circuit or the like using relatively high voltage is formed.

In the present modified example, the steps shown FIG. **2A** to FIG. **2E** in the modified example of Embodiment 1 are performed first to obtain the structure shown in FIG. **7A,** which is the same as the structure shown in FIG. **2E**.

Next, as shown in FIG. **7B,** a protection film for non-silicide region formation to be used in an analog region or the like (not shown) is formed while at the same time the protection film **17** having a thickness of, for example, approximately 20 nm is formed on the gate electrode **7A** in the core region. As the protection film **17,** an insulating film having an etching selectivity with respect to the interlayer insulating film **13** and the insulating sidewall spacers **8A, 8B** is used.

Subsequently, a metal film formed of a Ni film having a thickness of, for example, 10 nm is deposited on the entire surface of the substrate 1 including the gate electrodes **7A** and **7B,** and then, RTA is performed to form the on-gate silicide layer **12B** on the gate electrode **7B** and the on-source/drain silicide layers **12a** and **12b** respectively on the source/drain regions **10A** and **10B,** as shown in FIG. 7C. In RTA, the gate electrode **7A** is covered with the protection film 17, so that no silicide layer is formed on the gate electrode **7A.** Then, a non-reactive metal film remaining on the substrate **1** is removed.

Thereafter, the interlayer insulating film **13** having a thickness of, for example, 400 nm is deposited on the entire surface of the substrate **1** including the gate electrodes **7A** and **7B,** and the surface of the interlayer insulating film **13** is planarized by, for example, CMP to expose the protection film **17** on the gate electrode **7A,** as shown in FIG. **7D.** The protection film **17** serves as a stopper in CMP, thereby increasing controllability in CMP.

Next, as shown in FIG. **8A,** the protection film **17** exposed in the core region and the gate electrode **7A** therebelow are removed sequentially by etching to form the gate electrode formation trench **15,** thereby exposing the nitride film 5 within the gate electrode formation trench **15.**

Subsequently, as shown in FIG. **8B,** a metal film (preferably a film made of metal having a work function a little larger than 4 eV, such as TaN or the like) **16A** having a thickness of, for example, 170 nm is formed on the entire surface of the substrate **1** including the inside of the gate electrode formation trench **15**. Then, the metal film **16** outside the gate electrode formation trench **15** is polished and removed by CMP to form the metal gate electrode **16** formed of the metal film **16A** filled in the gate electrode formation trench **15**, as shown in FIG. **8C**.

Thereafter, as shown in FIG. **8D**, the interlayer insulating film **13** on the on-gate silicide layer **12B** and the upper part of the metal gate electrode **16** (a part thereof which is formed at a part where the protection film **17** has been removed) are polished and removed by CMP so as to expose the upper face of the on-gate silicide layer **12B** in the I/O region.

By the above steps of the comparatively simple semiconductor conductor manufacturing method, a semiconductor device exhibiting the same effects as in Embodiment 1 or the modified example thereof can be attained even in the case where the present invention is applied to a damascene gate (replacement gate) process.

In the present modified example, the following effects can be achieved when compared with Embodiment 5. Namely: Embodiment 5 requires formation of the resist pattern (not shown) opening to the core region and covering the I/O region on the interlayer insulating film 13 for forming the gate electrode formation trench **15**; In contrast, in the present modified example, in the case where no non-silicide gate electrode is needed, namely, in the case where all the gate electrodes other than the metal gate electrode are silicided, when the protection film **17** having a thickness of, for example, approximately 20 nm is formed on the gate electrode **7A** in the core region in the step of forming the protection film for non-silicide region formation to be used in the analog region or the like, removal of the protection film **17** and the gate electrode **7A** therebelow achieves formation of the gate electrode formation trench **15** without performing the mask forming step. In other words, the gate electrode formation trench **15** can be formed with no additional new step necessitated.

It is noted that though the total film thickness of the gate insulating film in the layered structure of the high dielectric insulating film **4A** and the nitride film **5** is set smaller than the film thickness of the gate oxide film **6** in the present modified example as in the modified example of Embodiment 1, the total film thickness of the gate insulating film in the layered structure of the high dielectric insulating film **4A** and the nitride film **5** may be set equal to the film thickness of the gate oxide film **6.**

Further, a HfSiON film is used as the high dielectric insulating film 4A in the present modified example as in the modified example of Embodiment 1, but the high dielectric insulating film **4A** may be made of any other suitable material, such as HfO₂, ZrO₂, TiO₂, Ta₂O₅, or the like.

In the present modified example, the nitride film 5 is formed on the high dielectric insulating film **4A,** as in the modified example of Embodiment 1. The same effects as in the present modified example can be achieved even when a nitride layer is formed in the upper part of the high dielectric insulating film 4A by nitriding the upper part.

Though the nitride film **5** is left on the high dielectric insulating film **4A** as a part of the gate insulating film of the N-type MIS transistor formed in the core region in the present modified example, the nitride film **5** may be removed after the gate oxide film 6 is formed and before the gate electrode **7A** is formed.

In the present modified example, a buffer insulating film formed of, for example, a silicon oxide film is preferably inserted between the substrate **1** and the high dielectric insulating film **4A.** This maintains the interface between the substrate **1** and the high dielectric insulating film **4A** properly.

The gate oxide film **6** is formed on the active region **1b** in the I/O region in the present modified example as in the modified example of Embodiment 1, but a gate insulating film formed of, for example, an SiON film may be formed in place thereof.

Furthermore, in the present modified example, the upper part of the high dielectric insulating film **4A** may be nitrided by thermal treatment performed for forming the nitride film 5 or the gate oxide film 6.

In the present modified example, the insulating sidewall spacers **8A, 8B** have a single-layer structure as in the modified example of Embodiment 1, but may have a two- or three-layer structure in combination of an oxide film and a nitride film, for example, .

The present modified example refers to the case where the N-type MIS transistors are formed in the core region and the I/O region, but P-type MIS transistors or CMOS transistors may be formed in place thereof. In the case where the P-type MIS transistors are formed, a material having a work function around 5eV, such as TaAlN or the like is preferable as the material of the metal gate electrode **16.**

In the present modified example, the upper part (a part thereof which is formed at a part where the protection film **17** has been removed) is removed in the step shown in FIG. **8D,** but this step may be omitted. In other words, the metal gate electrode **16** may remain in a hummer-like shape.

Further, the present modified example is directed to a semiconductor device including the core region and the I/O region, but may be directed to a semiconductor device including an N-channel region and a P-channel region or a semiconductor device including a Hvt region and a Lvt region with plural kinds of gate insulating films having different dielectric constants used on a single substrate.

### (Embodiment 6)

A semiconductor device and a manufacturing method thereof in accordance with Embodiment 6 of the present invention will be described below with reference to the drawings by referring to an example where the present invention is applied to N-type MIS transistors.

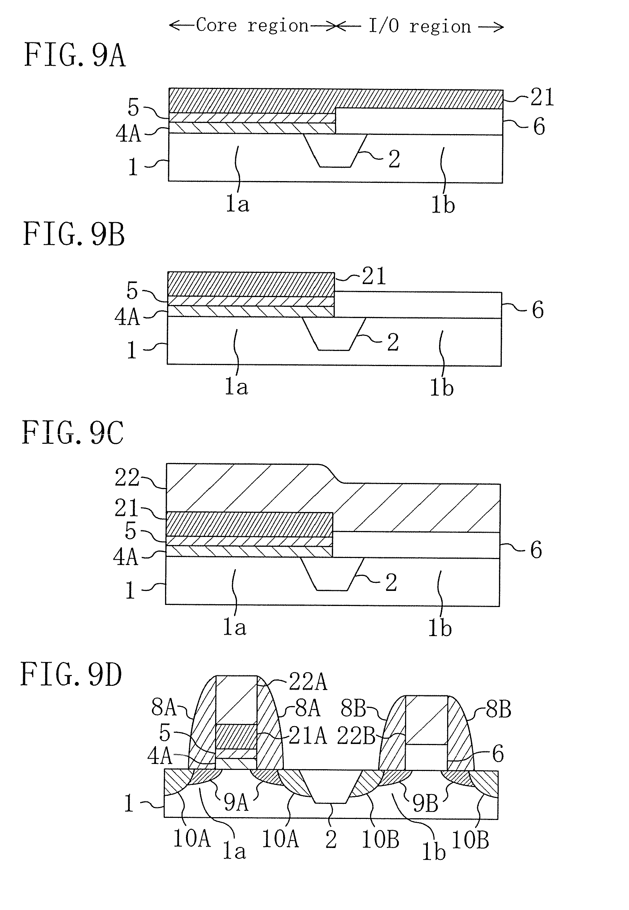

FIG. **9A** to FIG. **9D** are sectional views showing respective steps of the semiconductor device manufacturing method in accordance with the present embodiment. In the present embodiment, the core region means a region where an N-type MIS transistor composing a logic circuit or the like using relatively low voltage is formed, and the I/O region means a region where an N-type MIS transistor composing an I/O circuit or the like using relatively high voltage is formed.

In the present embodiment, the steps shown FIG. **1A** to FIG. **1C** in Embodiment 1 are performed first. Then, as shown in FIG. **9A,** a first gate electrode material film 21 formed of a metal film (preferably a film made of meal having a work function a little larger than 4 eV, such as TaN or the like) having a thickness of, for example, 10 nm is formed on the entire surface of the substrate **1.** Then, a resist pattern (not shown) covering the core region is formed, wet etching using, for example, SPM (Sulfuric acid-hydrogen Peroxide Mixture) is performed on the first gate electrode material film 21 with the use of the resist pattern as a mask to remove the first gate electrode material film **21** in the I/O region, and then, the resist pattern is removed, as shown in FIG. **9B.**

Next, as shown in FIG. **9C,** a second gate electrode material film **22** formed of a polysilicon film having a thickness of, for example, 90 nm is formed on the entire surface of the substrate **1.** Then, a resist pattern (not shown) covering the gate electrode formation region is formed on the second gate electrode material film **22,** and etching using the resist pattern as a mask is performed sequentially on the first gate electrode material film **21,** the second gate electrode material film **22,** the high dielectric insulating film **4A,** the nitride film **5,** and the gate oxide film **6.** Thus, a gate electrode in a layered structure of the first gate electrode material film (a metal gate electrode) **21A** and the second gate electrode material film (a polysilicon electrode) **22B** is formed on the active region **1a** in the core region, the gate insulating film in the layered structure of the high dielectric insulating film 4A and the nitride film **5** is interposed therebetween, and a gate electrode formed of the second gate electrode material film (a polysilicon electrode) **22B** is formed on the active region **1b** in the I/O region with the gate oxide film **6** interposed. Then, the N-type extension regions **9A,** the P-type pocket regions (not shown), the N-type LDD regions **9B,** the insulating sidewall spacers **8A, 8B** formed of the same insulating film, the N-type source/drain regions **10A,** and the N-type source/drain regions **10B** are formed, similarly to Embodiment 1. Namely, in the present embodiment, both the MIS transistor formed on the active region **1a** in the core region and the MIS transistor formed on the active region **1b** in the I/O region are N-type MIS transistors of the same conductivity type.

By the above steps of the comparatively simple manufacturing method, a semiconductor device exhibiting the same effects as in Embodiment 1 or the modified example thereof can be attained even in the case where the present invention is applied to a first gate process.

It is noted that though the total film thickness of the gate insulating film in the layered structure of the high dielectric insulating film **4A** and the nitride film 5 is set smaller than the film thickness of the gate oxide film **6** in the present embodiment as in the modified example of Embodiment 1, the total film thickness of the gate insulating film in the layered structure of the high dielectric insulating film **4A** and the nitride film 5 may be set equal to the film thickness of the gate oxide film **6.**

Further, a HfSiON film is used as the high dielectric insulating film **4A** in the present embodiment as in the modified example of Embodiment 1, but the high dielectric insulating film **4A** may be made of any other suitable material, such as HfO₂, ZrO₂ TiO₂, Ta₂O₅, or the like.

In the present embodiment, the nitride film 5 is formed on the high dielectric insulating film **4A,** as in the modified example of Embodiment 1. The same effects as in the present embodiment can be achieved even when a nitride layer is formed in the upper part of the high dielectric insulating film **4A** by nitriding the upper part.

Though the nitride film **5** is left on the high dielectric insulating film **4A** as a part of the gate insulating film of the N-type MIS transistor formed in the core region in the present embodiment, the nitride film **5** may be removed after the gate oxide film **6** is formed and before the first gate electrode material film **21** is formed.

In the present embodiment, a buffer insulating film formed of, for example, a silicon oxide film is preferably inserted between the substrate **1** and the high dielectric insulating film **4A.** This maintains the interface between the substrate **1** and the high dielectric insulating film **4A** properly.

The gate oxide film **6** is formed on the active region **1b** in the I/O region in the present embodiment, as in Embodiment 1, but a gate insulating film formed of, for example, an SiON film may be formed in place thereof.

Furthermore, in the present embodiment, the upper part of the high dielectric insulating film **4A** may be nitrided by thermal treatment performed for forming the nitride film **5** or the gate oxide film **6.**

In the present embodiment, the insulating sidewall spacers **8A, 8B** have a single-layer structure, as in Embodiment 1, but may have a two- or three-layer structure in combination of an oxide film and a nitride film.

The present embodiment refers to the case where the N-type MIS transistors are formed in the core region and the I/O region, but P-type MIS transistors or CMOS transistors may be formed in place thereof. In the case where the P-type MIS transistors are formed, a material having a work function around 5eV, such as TaAlN or the like is preferable as the material of the gate electrode material film **21** that is to be the metal gate electrode **16.**

Further, the present embodiment is directed to a semiconductor device including the core region and the I/O region, but may be directed to a semiconductor device including an N-channel region and a P-channel region or a semiconductor device including a Hvt region and a Lvt region with plural kinds of gate insulating films having different dielectric constants used on a single substrate.

### (Embodiment 7)

A semiconductor device and a manufacturing method thereof in accordance with Embodiment 7 of the present invention will be described below with reference to the drawings.

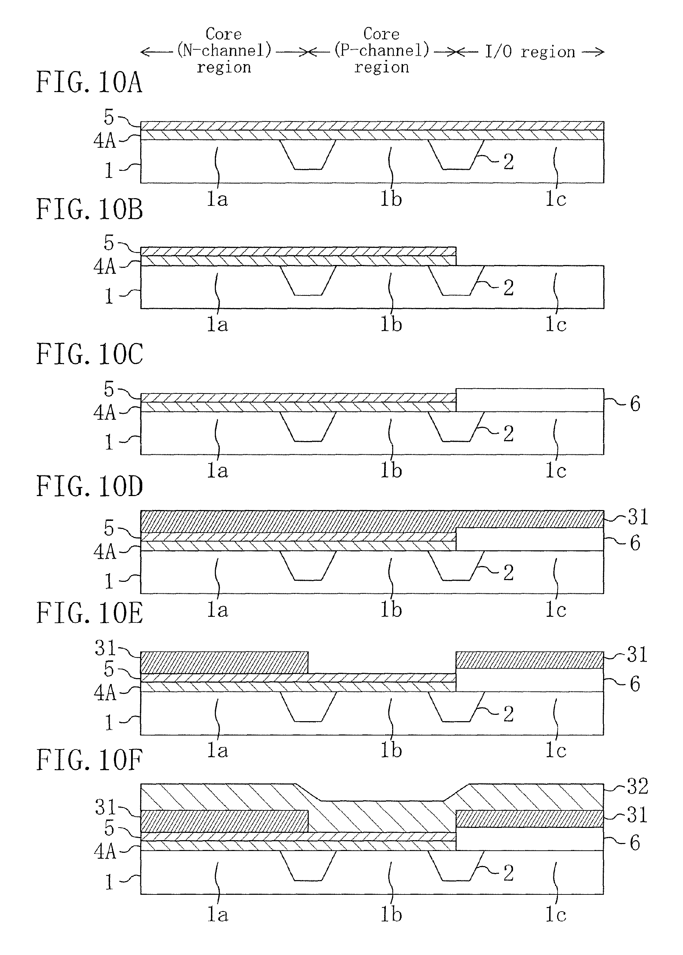

FIG. **10A** to FIG. **10F** and FIG. **11A** to FIG. **11D** are sectional views showing respective steps of the semiconductor device manufacturing method in accordance with the present embodiment. In the present embodiment, the core region means a region where an N-type MIS transistor composing a logic circuit or the like using relatively low voltage is formed, and the I/O region means a region where an N-type MIS transistor composing an I/O circuit or the like using relatively high voltage is formed. Further, in the present embodiment, the N-channel region means a region where an N-type MIS transistor is formed, and the P-channel region means a region where a P-type MIS transistor is formed.

First, as shown in FIG. **10A,** after isolation regions **2** made of, for example, STIs are formed in a substrate (semiconductor substrate) **1** of one conductivity type including a semiconductor region, for example, a silicon region or the like to define a core (N-channel) region, a core (P-channel) region, and an I/O region, the wells, the punch through stoppers, and the channel regions are formed, though not shown, by the same steps as in Embodiment 1. Whereby, regions surrounded by the isolation regions **2** in the substrate **1** serve as an active region **1a** in the core (N-channel) region, an active region **1b** in the core (P-channel) region, and an active region **1c** in the I/O region.

Next, a buffer insulating film (not shown) formed of a silicon oxide film having a thickness of, for example, 0.5 nm is formed on the substrate **1,** the high dielectric insulating film **4A** formed of a HfSiON film having a thickness of, for example, 4 nm (an equivalent oxide thickness of 1 nm) is formed on the buffer insulating film, and then, the nitride film (SiN film) **5** having a thickness of, for example, 2 nm is deposited on the high dielectric insulating film **4A.**

Subsequently, following formation of a resist pattern (not shown) covering the core (N-channel) region and the core (P-channel) region, etching using the resist pattern as a mask is performed sequentially on the nitride film **5** and the high dielectric insulating film **4A** to remove the nitride film **5** and the high dielectric insulating film **4A** on the active region **1c** in the I/O region for exposing the active region **1c,** and then, the resist pattern is removed, as shown in FIG. **10B.**

Thereafter, as shown in FIG. **10C,** the surface of the active region **1c** in the I/O region is selectively oxidized with the use of the nitride film **5** formed in the core (N-channel) region and the core (P-channel) region as a mask to form the gate oxide film **6** having a thickness of, for example, **8** nm on the active region **1c.**

Next, as shown in FIG. **10D,** a first gate electrode material film **31** formed of a metal film (preferably, a film made of metal having a work function a little larger than 4 eV, such as TaN or the like) having a thickness of, for example, 10 nm is formed on the entire surface of the substrate **1.** Then, a resist pattern (not shown) covering the core (N-channel) region and the I/O region is formed, wet etching using, for example, SPM is performed on the first gate electrode material film **31** with the use of the resist pattern as a mask to remove the first gate electrode material film **31** in the core (P-channel) region, and then, the resist pattern is removed, as shown FIG. 10E.

Subsequently, as shown in FIG. **10F**, a second gate electrode material film **32** formed of a metal film (a TiN film, a MoAlN film, or the like, for example) having a thickness of, for example, 15 nm is formed on the entire surface of the substrate 1, CMP, for example, is performed on the second gate electrode material film 32 to remove a part of the second gate electrode material film 32 which is located upper in level than the upper face of the first gate electrode material film 31 in the core (N-channel) region and the I/O region. Whereby, the second gate electrode material film 32 remains only in the core (P-channel) region, as shown in FIG. **11A.**

Thereafter, following formation of a resist pattern (not shown) covering the core (N-channel) region and the core (P-channel) region, wet etching using, for example, SPM is performed on the first gate electrode material film **31** with the use of the resist pattern as a mask to remove the first gate electrode material film **31** in the I/O region, and then, the resist pattern is removed, as shown in FIG. **11B.**

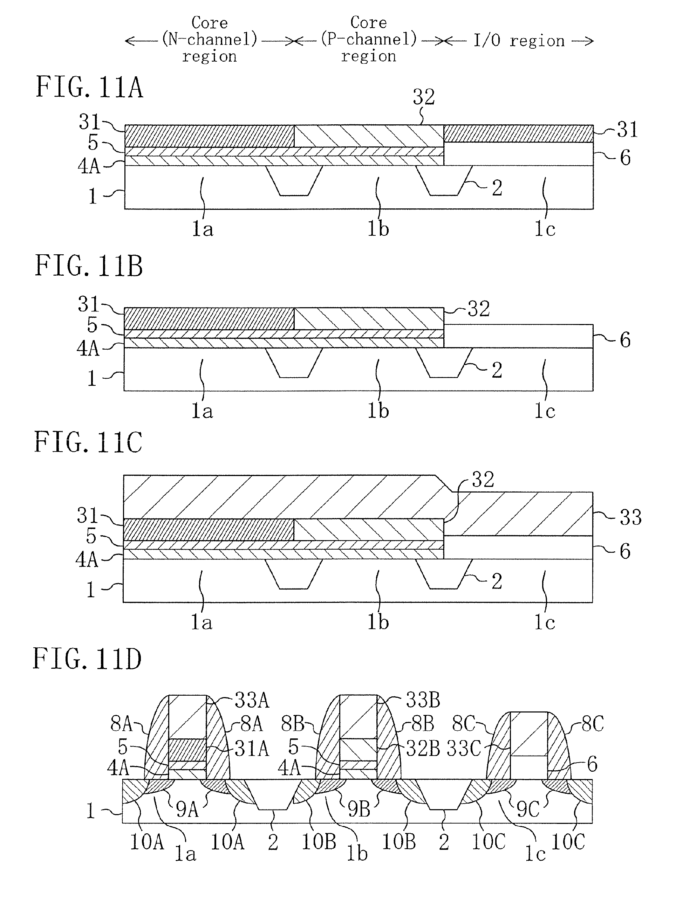

Next, as shown in FIG. **11C,** a third gate electrode material film **33** formed of a polysilicon film having a thickness of, for example, 90 nm is formed on the entire surface of the substrate **1.** Then, a resist pattern (not shown) covering the gate electrode formation region is formed on the third gate electrode material film **33,** etching using the resist pattern as a mask is performed sequentially on the first gate electrode material film **31,** the second gate electrode material film **32,** the third gate electrode material film **33,** the high dielectric insulating film **4A,** the nitride film **5,** and the gate oxide film **6.** This forms, as shown in FIG. **11D:** a gate electrode in a layered structure of the first gate electrode material film (a metal gate electrode) **31A** and the third gate electrode material film (a polysilicon electrode) **33A** on the active region **1a** in the core (N-channel) region (wherein the gate insulating film in the layered structure of the high dielectric insulating film **4A** and the nitride film **5** is interposed therebetween); a gate electrode in a layered structure of the second gate electrode material film (a metal gate electrode) **32B** and the third gate electrode material film (a polysilicon electrode) **33B** on the active region **1b** in the core (P-channel) region (wherein the gate insulating film in the layered structure of the high dielectric insulating film **4A** and the nitride film **5** is interposed therebetween); and a gate electrode formed of the third gate electrode material film (a polysilicon electrode) **33C** on the active region **1c** in the I/O region (wherein the gate oxide film **6** is interposed therebetween). Formed then by the same steps as those in Embodiment 1 are N-type extension regions **9A,** P-type pocket regions (not shown), P-type extension regions **9B,** N-type pocket regions (not shown), N-type LDD regions **9C,** insulating sidewall spacers **8A, 8B, 8C** formed of the same insulating film, N-type source/drain regions **10A,** P-type source/drain regions **10B,** and N-type source/drain regions **10C.**

By the above steps of the comparatively simple manufacturing method, a semiconductor device exhibiting the same effects as in Embodiment 1 or the modified example thereof can be attained even in the case where the present invention is applied to a first gate process.

In the present embodiment, the first gate electrode material film **31** in the I/O region is removed immediately before the step of forming the third gate electrode material film **33** formed of a polysilicon film shown in FIG. **11C.** This is because the first gate electrode material film **31** is used as a protection film of the gate oxide film **6** in the I/O region up to this step. Nevertheless, the first gate electrode material film **31** in the I/O region may be removed at the same time as the step of removing the first gate electrode material film **31** in the core (P-channel) region, as shown in FIG. **10E**.

It is noted that though the total film thickness of the gate insulating film in the layered structure of the high dielectric insulating film **4A** and the nitride film 5 is set smaller than the film thickness of the gate oxide film **6** in the present embodiment, as in the modified example of Embodiment 1, the total film thickness of the gate insulating film in the layered structure of the high dielectric insulating film **4A** and the nitride film **5** may be set equal to the film thickness of the gate oxide film **6.**

Further, a HfSiON film is used as the high dielectric insulating film **4A** in the present embodiment as in the modified example of Embodiment 1, but the high dielectric insulating film **4A** may be made of any other suitable material, such as HfO₂, ZrO₂, TiO₂, Ta₂O₅, or the like.

In the present embodiment, the nitride film **5** is formed on the high dielectric insulating film **4A,** as in the modified example of Embodiment 1. The same effects as in the present embodiment can be achieved even when a nitride layer is formed in the upper part of the high dielectric insulating film **4A** by nitriding the upper part.

Though the nitride film **5** is left on the high dielectric insulating film **4A** as parts of the gate insulating films of the MIS transistors formed in the core (N-channel) region and the core (P-channel) region in the present embodiment, the nitride film 5 may be removed after the gate oxide film **6** is formed and before the first gate electrode material film **31** or the second gate electrode material film **32** is formed.

In the present embodiment, a buffer insulating film formed of, for example, a silicon oxide film is preferably inserted between the substrate 1 and the high dielectric insulating film **4A.** This maintains the interface between the substrate 1 and the high dielectric insulating film **4A** properly.

The gate oxide film **6** is formed on the active region **1b** in the I/O region in the present embodiment, as in Embodiment 1, but a gate insulating film formed of, for example, an SiON film may be formed in place thereof.

Furthermore, in the present embodiment, the upper part of the high dielectric insulating film **4A** may be nitrided by thermal treatment performed for forming the nitride film **5** or the gate oxide film **6.**

In the present embodiment, the insulating sidewall spacers **8A, 8B,** and **8C** have a single-layer structure, as in Embodiment 1, but may have a two- or three-layer structure in combination of an oxide film and a nitride film, for example.

The present embodiment refers to the case where the N-type MIS transistor is formed in the I/O region, but a P-type MIS transistor or a CMOS transistor may be formed in place thereof.

In addition, the present embodiment is directed to a semiconductor including three regions including the core regions and the I/O region, but may be directed to a semiconductor device including four or more regions including a core region and an I/O region, a semiconductor device including three or more regions including an N-channel region and a P-channel region, or a semiconductor device including three or more regions including a Hvt region and a Lvt region with plural kinds of gate insulating films having different dielectric constants used on a single substrate.

### (Embodiment 8)

A semiconductor device and a manufacturing method thereof in accordance with Embodiment 8 of the present invention will be described below with reference to the drawings by referring an example where the structure in the present embodiment is applied to N-type MIS transistors. The present invention is applied to a dual oxide process in the modified example of Embodiment 1. While in the present embodiment, description will be made to the case where the present invention is applied to a triple oxide process.

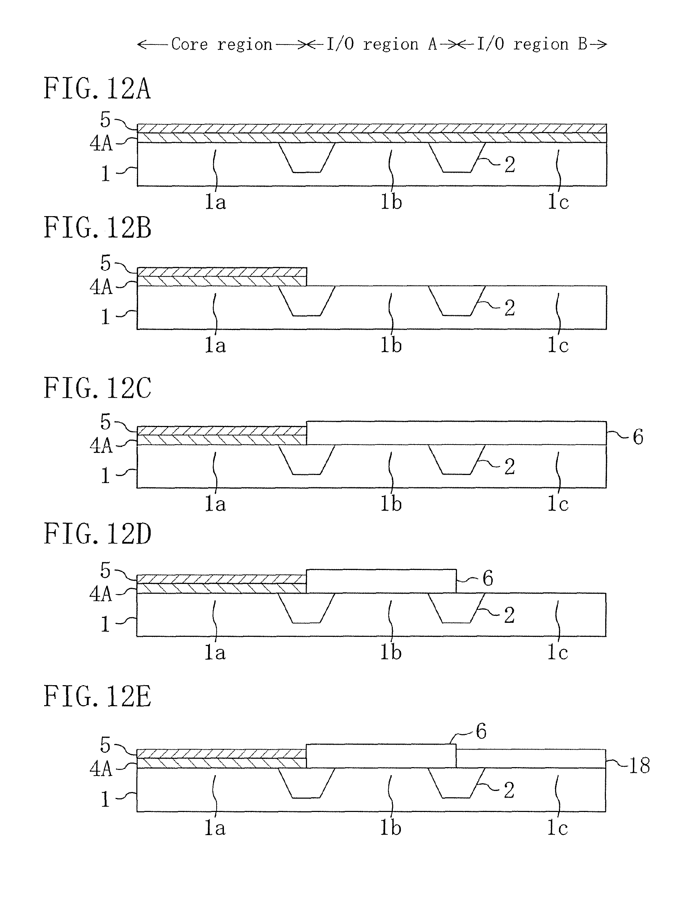

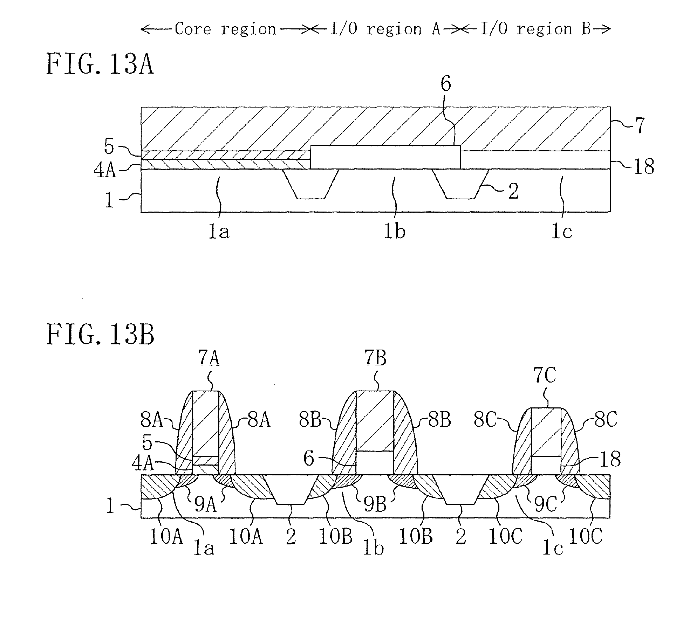

FIG. **12A** to FIG. **12E** and FIG. **13A** to FIG. **13B** are sectional views showing respective steps of the semiconductor device manufacturing method in accordance with the present embodiment. In FIG. **12A** to FIG. **12E** and FIG. **13A** to FIG. **13B,** the same reference numerals are assigned to the same elements as those in Embodiment 1 shown in FIG. **1A** to FIG. **1F** or in the modified example thereof shown in FIG. **2A** to FIG. **2G** for omitting duplicate description. Further, in the present embodiment, the core region means a region where an N-type MIS transistor composing a logic circuit or the like using relatively low voltage is formed, and the I/O region (two regions of an I/O region A and an I/O region **B** in the present embodiment) means a region where an N-type MIS transistor composing an I/O circuit or the like using relatively high voltage is formed.

First, as shown in FIG. **12A,** isolation regions **2** made of, for example, STIs are formed in a substrate (semiconductor substrate) **1** of one conductivity type including a semiconductor region, for example, a silicon region or the like to define the core region, the I/O region **A,** and the I/O region **B,** and then, the P-type wells, the P-type punch through stoppers, and the P-type channels are formed, though not shown. Whereby, regions surrounded by the isolation regions **2** in the substrate **1** serve as an active region **1a** in the core region, an active region **1b** in the I/O region **A,** and an active region **1c** in the I/O region **B.** Referring to implantation conditions, for example: ion implantation of B at a dose of 1x10¹³ cm⁻² at an implantation energy of 300 keV is performed for forming the P-type wells; ion implantation of B at a dose of 1x10¹³ cm⁻² at an implantation energy of 150 keV is performed for forming the P-type punch through stoppers; and ion implantation of B at a dose of 3x10¹² cm⁻² at an implantation energy of 20 keV is performed for forming the P-type channels.

Next, following formation of a resist pattern (not shown) covering the core region and the I/O region **A,** B ion at a dose of 2x10¹² cm⁻² is implanted at an ion implantation energy of 20 eV into only the P-type channel of the active region **1c** in the I/O region **B** with the use of the resist pattern as a mask, and then, the resist pattern is removed. Then, after a resist pattern (not shown) covering the I/O region A and the I/O region **B** is formed, B ion at a dose of 5x10¹² cm⁻² is implanted at an ion implantation energy of 20 eV into only the P-type channel of the active region **1a** in the core region with the use of the resist pattern as a mask, and then, the resist pattern is removed.

Subsequently, following formation of a buffer insulating film (not shown) formed of a silicon oxide film having a thickness of, for example, 0.5 nm on the substrate **1,** the high dielectric insulating film **4A** formed of a HfSiON film having a thickness of 4 nm (an equivalent oxide thickness of 1 nm) is formed on the buffer insulating film, and then, the nitride film (SiN film) 5 having a thickness of, for example, 2 nm is deposited on the high dielectric insulating film **4A.**

Thereafter, following formation of a resist pattern (not shown) covering the core region, etching using the resist pattern as a mask is performed sequentially on the nitride film 5 and the high dielectric insulating film **4A** to remove the nitride film **5** and the high dielectric insulating film **4A** in the I/O region **A** and the I/O region **B** for exposing the active region **1b** and the active region **1c,** and then, the resist pattern is removed, as shown in FIG. **12B.**

Next, as shown in FIG. **12C,** the surface of the substrate 1 in the I/O region **A** and the I/O region **B** is oxidized with the use of the nitride film **5** in the core region as a mask to form the gate oxide film 6 having a thickness of, for example, 7 nm on the active region **1b** in the I/O region **A** and the active region **1c** in the I/O region **B.**

Subsequently, following formation of a resist pattern (not shown) covering the core region and the I/O region **A,** etching using the resist pattern as a mask is performed on the gate oxide film 6 to remove the gate oxide film 6 in the I/O region **B** for exposing the active region **1c,** and then, the resist pattern is removed, as shown in FIG. **12D.**

Thereafter, as shown in FIG. **12E,** the surface of the substrate **1** in the I/O region **B** is oxidized with the use of the nitride film **5** in the core region as a mask to form a gate oxide film **18** having a thickness of, for example, 3 nm on the active region **1c** in the I/O region **B.** In oxidation, the gate oxide film 6 in the I/O region A grows by approximately 1 nm in thickness to have a thickness of approximately 8 nm.

Next, as shown in FIG. **13A**, the gate electrode material film **7** having a thickness of, for example, 100 nm is deposited on the nitride film 5 and the gate oxide films **6** and **18** with the nitride film **5** in the core region left.

Subsequently, following formation of a resist pattern (not shown) covering the gate electrode formation region on the gate electrode material film **7,** etching using the resist pattern as a mask is performed sequentially on the gate electrode material film **7,** the nitride film **5,** the high dielectric insulating film **4A,** the gate oxide film **6,** and the gate oxide film **18** to form: a gate electrode **7A** on the active region **1a** in the core region (wherein the gate insulating film formed of the high dielectric insulating film **4A** and the nitride film **5** is interposed therebetween); a gate electrode **7B** on the active region **1b** in the I/O region **A** with the gate oxide film 6 interposed; and a gate electrode 7C on the active region **1c** in the I/O region **B** with the gate oxide film **18** interposed, as shown in FIG. **13B.** Then, N-type extension regions **9A** are formed under the respective sides of the gate electrode **7A** in the active region **1a** in the core region, and P-type pocket regions (not shown) are formed below the N-type extension regions **9A.** On the other hand, N-type LDD regions **9B** are formed under the respective sides of the gate electrode **7B** in the active region **1b** in the I/O region **A** while at the same time N-type LDD regions **9C** are formed under the respective sides of the gate electrode **7C** in the active region **1c** in the I/O region **B.**

Thereafter, insulating sidewall spacers **8A, 8B, 8C** formed of the same insulating film are formed on the side faces of the gate electrodes **7A, 7B, 7C,** respectively. In formation, the high dielectric insulating film **4A** and the nitride film **5** may be left below the insulating sidewall spacers **8A,** the gate oxide film **6** may be left below the insulating sidewall spacers **8B,** and the gate oxide film **18** may be left below the insulating sidewall spacers **8C.**

Next, an N-type impurity is implanted into the active region **1a** in the core region, the active region **1b** in the I/O region **A,** and the active region **1c** in the I/O region **B** with the use of the gate electrodes **7A, 7B, 7C** and the sidewall spacers **8A, 8B, 8C** as a mask. Then, spike RTA at a temperature of, for example, approximately 1050 °C is performed to activate the implanted impurity, thereby forming: N-type source/drain regions **10A** under the respective sides of the insulating sidewall spacers **8A** as viewed from the gate electrode **7A** in the active region **1a** in the core region; N-type source/drain regions **10B** under the respective sides of the insulating sidewall spacers **8B** as viewed from the gate electrode **7B** in the active region **1b** in the I/O region **A;** and N-type source/drain regions **10C** under the respective sides of the insulating sidewall spacers 8C as viewed from the gate electrode **7C** in the active region **1c** in the I/O region **B.** Namely, in the present embodiment, all of the MIS transistor formed on the active region **1a** in the core region, the MIS transistor formed on the active region **1b** in the I/O region **A,** and the MIS transistor formed on the active region **1c** in the I/O region **B** are N-type MIS transistors of the same conductivity type.

In the semiconductor device formed by the above steps in accordance with the present embodiment, the gate insulating film formed of the high dielectric insulating film **4A** and the nitride film **5** is used as the gate insulating film of the MIS transistor formed in the core region using relatively low voltage (for example, approximately 1 V). In contrast, the gate oxide film **6** is used as the gate insulating film of the MIS transistor formed in the I/O region **A** using relatively high voltage (for example, approximately 3 V). Further, the gate oxide film **18** thinner than the gate oxide film **6** is used as the gate insulating film of the MIS transistor formed in the I/O region **B** using middle-level voltage (for example, approximately 2 V). Accordingly, in the present embodiment, the gate insulating films of the N-type MIS transistors formed in the I/O region **A** and the I/O region **B** respectively using relatively high voltage and the middle-level voltage includes no high dielectric insulating film. This prevents reliability lowering, which is caused due to application of high voltage to a gate electrode formed on a high dielectric insulating film in an N-type MIS transistor formed in the I/O region **A** or the I/O region **B.**

Hence, the present embodiment achieves the same effects as in Embodiment 1. Employment of the layered structure of the high dielectric insulating film **4A** and the nitride film **5** as the gate insulating film of the N-type MIS transistor formed in the core region, in other words, insertion of the nitride film **5** between the high dielectric insulating film **4A** and the gate electrode **7A** suppresses lowering of the dielectric constant to a minimum and prevents the leak current characteristics and the reliability from lowering.

It is noted that though the total film thickness of the gate insulating film in the layered structure of the high dielectric insulating film **4A** and the nitride film 5 is set smaller than the film thickness of the gate oxide film **6** in the present embodiment, the total film thickness of the gate insulating film in the layered structure of the high dielectric insulating film **4A** and the nitride film 5 may be set equal to the film thickness of the gate oxide film **6.**

Further, a HfSiON film is used as the high dielectric insulating film **4A** in the present embodiment, but the high dielectric insulating film **4A** may be made of any other suitable material, such as HfO₂, ZrO₂, TiO₂, Ta₂O₅, or the like.

In the present embodiment, the nitride film 5 is formed on the high dielectric insulating film **4A.** The same effects as in the present embodiment can be achieved even when a nitride layer is formed in the upper part of the high dielectric insulating film **4A** by nitriding the upper part.

Though the nitride film **5** is left on the high dielectric insulating film **4A** as a part of the gate insulating film of the N-type MIS transistor formed in the core region in the present embodiment, the nitride film **5** may be removed after the gate oxide film **6** or **18** is formed and before the gate electrode **7A** is formed.

In the present embodiment, a buffer insulating film formed of, for example, a silicon oxide film is preferably inserted between the substrate **1** and the high dielectric insulating film **4A.** This maintains the interface between the substrate **1** and the high dielectric insulating film **4A** properly.

The gate oxide films **6** and **18** are formed as the gate insulating films in the I/O region **A** and the I/O region **B,** respectively, in the present embodiment, but gate insulating films each formed of, for example, a SiON film may be formed in place thereof.

Furthermore, in the present embodiment, each of some or all of the gate electrodes **7A** to **7C** may be a polysilicon electrode formed of a polysilicon film having a conductivity type opposite to that of the corresponding wells. In this case, each upper part of the polysilicon electrode(s) may be silicided. Alternatively, all of the gate electrodes **7A** to **7C** may be fully silicided gate electrodes, or each of some or all of the gate electrodes **7A** to **7C** may be a metal gate electrode. Alternatively, the gate electrode **7A** may be a fully silicided electrode when the gate electrodes **7B, 7C** include polysilicon electrodes. In other words, the gate electrodes **7A** to **7C** may be made of different materials.

In the present embodiment, the upper part of the high dielectric insulating film **4A** may be nitrided by thermal treatment performed for forming the nitride film **5** or the gate oxide film **6.**

In the present embodiment, the insulating sidewall spacers **8A** to **8C** have a single-layer structure, but may have a two- or three-layer structure in combination of an oxide film (a SiO₂ film) and a nitride film, for example.

The present embodiment refers to the case where the N-type MIS transistors are formed in the core region, the I/O region **A,** and the I/O region **B,** but P-type MIS transistors or CMOS transistors may be formed in place thereof.

In addition, the present embodiment is directed to a semiconductor device including three regions including the core region and the I/O regions, but may be directed to a semiconductor device including four or more regions including a core region and an I/O region, a semiconductor device including three or more regions including an N-channel region and a P-channel region, or a semiconductor device including three or more regions including a Hvt region and a Lvt region with plural kinds of gate insulating films having different dielectric constants used on a single substrate.

## Claims

1. A semiconductor device, comprising a first MIS transistor and a second MIS transistor,
wherein the first MIS transistor includes:
a first gate insulating film formed on a first active region of a substrate; and
a first gate electrode formed on the first gate insulating film,
the second MIS transistor includes:
a second gate insulating film formed on a second active region of the substrate and having a dielectric constant lower than the first gate insulating film; and
a second gate electrode formed on the second gate insulating film, and insulting sidewall spacers having the same structure are formed on respective side
faces of the first gate electrode and the second gate electrode.

2. The semiconductor device of Claim 1,
wherein the first gate insulating film has a film thickness equal to or smaller than the second gate insulating film.

3. The semiconductor device of Claim 1,
wherein the first MIS transistor and the second MIS transistor have the same conductivity type, and
an operation voltage of the first MIS transistor is lower than an operation voltage of the second MIS transistor.

4. The semiconductor device of Claim 1,
wherein the first gate insulating film has a film thickness larger than the second gate insulating film.

5. The semiconductor device of Claim 1,
wherein the first MIS transistor is an N-type MIS transistor, and
the second MIS transistor is a P-type MIS transistor.

6. The semiconductor device of Claim 1,
wherein the first MIS transistor and the second MIS transistor have the same conductivity type,
an operation voltage of the first MIS transistor is equal to an operation voltage of the second MIS transistor, and
a threshold voltage of the first MIS transistor is higher than a threshold voltage of the second MIS transistor.

7. The semiconductor device of Claim 1,
wherein the first gate insulating film includes a high dielectric insulating film.

8. The semiconductor device of Claim 7,
wherein a SiN film is formed on the high dielectric insulating film.

9. The semiconductor device of Claim 7,
wherein the high dielectric insulating film includes a nitrided upper part.

10. The semiconductor device of Claim 7,
wherein a buffer insulating film is formed below the high dielectric insulating film.

11. The semiconductor device of Claim 1,
wherein the second gate insulating film is a SiO₂ film or a SiON film.

12. The semiconductor device of Claim 1,
wherein the first gate electrode is a fully silicided electrode, and
the second gate electrode is a fully silicided electrode or includes a polysilicon electrode.

13. The semiconductor device of Claim 1,
wherein the first gate electrode and the second gate electrode are metal gate electrodes.

14. The semiconductor device of Claim 1,
wherein the first gate electrode is a metal gate electrode, and
the second gate electrode includes a polysilicon electrode in contact with the second gate insulating film.

15. The semiconductor device of Claim 1,
wherein the first gate electrode includes a metal gate electrode in contact with the first gate insulating film, and
the second gate electrode includes a polysilicon electrode in contact with the second gate insulating film.

16. The semiconductor device of Claim 15, further comprising a third MIS transistor,
wherein the third MIS transistor includes:
a third gate insulating film formed on a third active region of the substrate and formed of the same insulating film as the first gate insulating film; and
a third gate electrode formed on the third gate insulating film,
the third gate electrode includes another metal gate electrode in contact with the third gate insulating film, and
insulating sidewall spacers having the same structure as the said insulating sidewall spacers are formed on the respective side faces of the third gate electrode.

17. The semiconductor device of Claim 1, further comprising a third MIS transistor,
wherein the third MIS transistor includes:
a third gate insulating film formed on a third active region of the substrate and having a dielectric constant lower than the first gate insulating film; and
a third gate electrode formed on the third gate insulating film, and insulating sidewall spacers having the same structure as the said insulating sidewall spacers are formed on the respective side faces of the third gate electrode.

18. A method for manufacturing a semiconductor device including a first MIS transistor including a first gate insulating film and a first gate electrode and a second MIS transistor including a second gate insulating film and a second gate electrode, the method comprising the steps of:
(a) forming the first gate insulating film on a first active region of a substrate;
(b) forming the second gate insulating film, which has a dielectric constant lower than the first gate insulating film, on a second active region of the substrate;
(c) forming the first gate electrode on the first gate insulating film;
(d) forming the second gate electrode on the second gate insulating film; and
(e) forming insulating sidewall spacers having the same structure on respective side faces of the first gate electrode and the second gate electrode.

19. The method of Claim 18,
wherein the first gate insulating film has a film thickness equal to or smaller than the second gate insulating film.

20. The method of Claim 18,
wherein the first MIS transistor and the second MIS transistor have the same conductivity type, and
an operation voltage of the first MIS transistor is lower than an operation voltage of the second MIS transistor.

21. The method of Claim 18,
wherein the first gate insulating film has a film thickness larger than the second gate insulating film.

22. The method of Claim 18,
wherein the first MIS transistor is an N-type MIS transistor, and
the second MIS transistor is a P-type MIS transistor.

23. The method of Claim 18,
wherein the first MIS transistor and the second MIS transistor have the same conductivity type,
an operation voltage of the first MIS transistor is equal to an operation voltage of the second MIS transistor; and
a threshold voltage of the first MIS transistor is higher than a threshold voltage of the second MIS transistor.

24. The method of Claim 18,
wherein the step (a) includes a step of forming, after forming a high dielectric insulating film on the first active region, an SiN film on the high dielectric insulating film, and
the step (b) includes a step of forming the second gate insulating film on the second active region by oxidizing the substrate with the use of the SiN film as a mask after the step (a).

25. The method of Claim 24, further comprising the step of:
removing the SiN film after the step (b) and before the step (c).

26. The method of Claim 18,
wherein the step (a) includes a step of forming, after forming a high dielectric insulating film on the first active region, a nitride layer by nitriding an upper part of the high dielectric insulating film, and
the step (b) includes a step of forming the second gate insulating film on the second active region by oxidizing the substrate with the use of the nitride layer as a mask after the step (a).

27. The method of Claim 26, further comprising the step of:
removing the nitride layer after the step (b) and before the step (c).

28. The method of Claim 24,
wherein the step (a) includes a step of forming, before forming the high dielectric insulating film, a buffer insulating film on the first active region.

29. The method of Claim 18,
wherein the second gate insulating film is a SiO₂ film or a SiON film.

30. The method of Claim 18,
wherein the first gate electrode and the second gate electrode are made of polysilicon,
the method comprising the step of:
fully siliciding at least the first gate electrode after the step (c).

31. The method of Claim 18,
wherein the first gate electrode and the second gate electrode are metal gate electrodes.

32. The method of Claim 18,
wherein in the step (c), a dummy gate electrode is formed in place of the first gate electrode,
the method further comprising the steps of:
(f) removing, after the step (e), the dummy gate electrode and forming a metal gate electrode as the first gate electrode in a recessed portion formed by the removal.

33. The method of Claim 32,
wherein the second gate electrode is formed of a silicon-containing film,
the method further comprising the step of:
forming a protection film covering the dummy gate electrode and siliciding a surface portion of the second gate electrode with the use of the protection film as a mask between the step (e) and the step (f),
wherein in the step (f), the protection film is removed together with the dummy gate electrode.

34. The method of Claim 18,
wherein in the step (c) and the step (d): a metal film is formed on the first gate insulating film; a polysilicon film is formed on the metal film and the second gate insulating film; and then, patterning is performed on the metal film and the polysilicon film on the first gate insulating film and the polysilicon film on the second gate insulating film to form the first gate electrode and the second gate electrode.

35. The method of Claim 18,
wherein the semiconductor device further includes a third MIS transistor including a third gate insulating film and a third gate electrode,
in the step (a), the third gate insulating film, which is made of the same insulating film as the first gate insulating film, is formed on a third active region of the substrate,
in the step (c) and the step (d): a first metal film is formed on the first gate insulating film while a second metal film is formed on the third gate insulating film; a polysilicon film is formed on the first metal film, the second metal film, and the second gate insulating film; and then, patterning is performed on the first metal film and the polysilicon film on the first gate insulating film, the polysilicon film on the second gate insulating film, and the second metal film and the polysilicon film on the third gate insulating film to form the first gate electrode, the second gate electrode, and the third gate electrode, respectively, and
in the step (e), insulating sidewall spacers having the same structure as the said insulating sidewall spacers are formed on the respective side faces of the third gate electrode.

36. The method of Claim 18,
wherein the semiconductor device further includes a third MIS transistor including a third gate insulating film and a third gate electrode,
the method further comprising the steps of:
(g) forming the third gate insulating film, which has a dielectric constant lower than the first gate insulating film, on a third active region of the substrate before the step (c) and the step (d); and
(h) forming the third gate electrode on the third gate insulating film between the step (g) and the step (e),
wherein in the step (e), insulating sidewall spacers having the same structure as the said insulating sidewall spacers are formed on the respective side faces of the third gate electrode.
